(19) Europäisches Patentamt
European Patent Office
Office européen des brevets

(11) **EP 1 986 330 B1**

(12) **FASCICULE DE BREVET EUROPEEN**

(45) Date de publication et mention de la délivrance du brevet:
**07.08.2019 Bulletin 2019/32**

(51) Int Cl.:
***H03M 13/27*** *(2006.01)*

(21) Numéro de dépôt: **08160263.3**

(22) Date de dépôt: **19.12.2005**

(54) **Entrelacement avec calcul iteratif des l'adresses d'entrelacement**

Verschachtelung mit iterativer Berechnung der Verschachtelungsadressen

Interleaving with iterative computation of interleaving addresses

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **31.12.2004 FR 0414113**

(43) Date de publication de la demande:
**29.10.2008 Bulletin 2008/44**

(62) Numéro(s) de document de la (des) demande(s) initiale(s) en application de l'article 76 CBE:
**05850579.3 / 1 864 383**

(73) Titulaire: **Orange**
**75015 Paris (FR)**

(72) Inventeurs:
• **Siaud, Isabelle**
**35000 Rennes (FR)**
• **Ulmer-Moll, Anne-Marie**
**35700 Rennes (FR)**

(56) Documents cités:
**US-A- 3 652 998**

• **CROZIER S ET AL: "High-performance low-memory interleaver banks for turbo-codes" VTC FALL 2001. IEEE 54TH. VEHICULAR TECHNOLOGY CONFERENCE. PROCEEDINGS. ATLANTIC CITY, NJ, OCT. 7 - 11, 2001, IEEE VEHICULAR TECHNOLGY CONFERENCE, NEW YORK, NY : IEEE, US, vol. VOL. 1 OF 4. CONF. 54, 7 octobre 2001 (2001-10-07), pages 2394-2398, XP010562400 ISBN: 0-7803-7005-8**

EP 1 986 330 B1

**Description**

La présente invention se rapporte au domaine des télécommunications. Au sein de ce domaine, l'invention se rapporte plus particulièrement aux communications dites numériques. Les communications numériques comprennent en particulier les communications sans fil dont le canal de transmission est le canal aérien ainsi que les communications filaires.

L'invention concerne les techniques d'entrelacement. Ces techniques sont généralement mises en oeuvre pour réduire la corrélation introduite par une opération de filtrage 'sélectif appliquée sur des données et inhérente au canal de transmission ou pour réduire la corrélation introduite par la mise en forme des données.

L'invention s'applique en particulier à tout type de système de transmission filaire ou radio dont les données à transmettre sont discrètes et soumises à une perturbation qui introduit une corrélation entre les données en réception ayant pour effet de dégrader le circuit de décision du récepteur.

Lorsque le support de transmission est multi trajets, l'inverse de la bande de transmission B allouée à la transmission fournit la résolution des échos 'perçus' par le système ($\delta\tau \cong 1/B$). Ces échos (amplitude complexe et retard) sont générés par les ondes réfléchies et diffractées sur les obstacles au voisinage de l'axe émetteur-récepteur. Ils décrivent les coefficients de la réponse impulsionnelle du canal de propagation qui filtre le signal de communication dans la bande passante du système. Pour une transmission large bande sur une bande B (B> bande de cohérence du canal), un entrelaceur à petite échelle permet de réduire à l'échelle de quelques symboles la corrélation des données introduite par la sélectivité fréquentielle du canal de propagation. Lors d'une transmission bande étroite (B<Bande de cohérence du canal), la corrélation entre les données est liée aux variations bande étroite du champ radioélectrique ou bien à une opération de filtrage passe-bas idéal opérée sur les données. L'entrelacement des données émises sur une période supérieure au temps de cohérence du canal permet en réception, après desentrelacement, de décorréler les données et de disséminer les données à faible rapport signal à bruit. Cette opération améliore l'efficacité des circuits de décision en réception d'un système numérique de transmission.

Une loi d'entrelacement I(k) d'un bloc de taille K donne l'ordre suivant lequel doit être lue, en sortie, une séquence d'entrée formée par K données indicées par un indice k variant de 0 à K-1. Soit $X(k)$ une séquence en entrée d'un entrelaceur de loi d'entrelacement I(k). Soit $Y(k)$ la séquence en sortie de l'entrelaceur. Alors $Y(k) = X(I(k))$ : la kième donnée de la séquence entrelacée ayant l'indice de position k-1 correspond à la donnée d'indice I(k-1) de la séquence d'entrée X(0),...,X(K-1). La loi d'entrelacement I(k) est une fonction bijective qui prend ses valeurs dans l'espace S={0, ...K-1}. On définit la dispersion comme étant la plus petite distance après entrelacement entre deux indices de position associés à deux données d'entrée séparées par s-1 données, X(k) et X(k+s). La dispersion est donnée par la relation $\Delta I_{eff}(s) = Min_{k,k \in S}|I(k+s)-I(k)|$. La fonction $|X|$ fournit la valeur absolue de X.

Les données d'entrée à entrelacer et les données entrelacées de sortie sont représentées dans la suite du document uniquement par leur indice k, sauf indication contraire.

L'invention concerne plus particulièrement les techniques d'entrelacement bloc. C'est-à-dire les techniques d'entrelacement pour lesquelles chaque bloc de données de taille K est entrelacé de façon indépendante d'un autre bloc ; dans ces conditions, l'indice k varie de 0 à K-1.

Parmi ces techniques, certaines sont plus destinées à combattre les évanouissements rapides et certaines sont plus destinées à améliorer les circuits de décodage, notamment pour les turbo-codes.

Parmi les algorithmes d'entrelacement pour les turbo-codes, on connaît les algorithmes dits RP, Relative Prime interleavers, décrits en particulier dans l'article de S. Crozier et P. Guinand, ayant pour titre "High-Performance Low-Memory Interleaver Banks for Turbo-Codes", et pour références : Proceedings of the 54th IEEE Vehicular Technology Conference (VTC 2001 Fall), Atlantic City, New Jersey, USA, pp. 2394-2398, October 7-11, 2001.

Les algorithmes RP ont été définis à l'origine pour générer les matrices d'entrelacement internes aux turbo codes. Ces algorithmes, qui sont des algorithmes d'entrelacement bloc sur un bloc de taille K, fournissent une dispersion déterminée entre deux données entrelacées. Ils sont connus pour leur propriété de dispersion assez élevée sur des tailles de blocs relativement courts. En revanche, sur des blocs de taille élevée, une dispersion importante introduit un nombre élevé de données non entrelacées insérées dans une structure périodique. Ces algorithmes consistent à générer une loi d'entrelacement décrite par deux paramètres s et d et par une opération modulo K. s correspond à un décalage sur la première donnée et d correspond à la distance entre deux données successives après entrelacement ; d permet de fixer la valeur de la dispersion entre deux données entrelacées successives. d doit être premier avec K. Ces algorithmes permettent dans certains cas de préserver un motif de taille p. L'avantage d'une telle propriété est d'alléger l'infrastructure d'un système à entrelacement multi-voies et de répondre à des contraintes spécifiques associées à l'optimisation globale du système de transmission.

Préserver un motif de répartition de données correspondant à p flux de données multiplexées sous-entend que le paramètre p est un sous-multiple de la taille du bloc K à entrelacer : les séquences de données en entrée S et en sortie S' sont formées par K/p partitions $\mathscr{P}$ constituées chacune de p données. Préserver un motif signifie que l'ordonnancement des p flux de données dans chaque partition $\mathscr{P}$ est conservé après l'opération d'entrelacement. Au sein d'une partition de taille p, chaque donnée appartenant à un flux i, i={1, ...,p} conserve son rang après l'opération d'entrelacement. La donnée à la position i dans la séquence après entrelacement n'est évidemment plus la même mais elle appartient au même flux i. Cette propriété se traduit par le fait que la différence entre l'indice de position de la donnée entrelacée et son rang dans la séquence entrelacée est multiple de p, ce qui peut s'exprimer par l'équation suivante :

$$I(k) - k = Q(k) \times p \qquad (1)$$

avec k={0,....,K-1} et Q(k) une fonction dans l'espace des entiers relatifs telle que quel que soit k : $Q(k) \times p < K$.

Ainsi, un motif de taille p est préservé si la relation (1) est satisfaite : la différence entre les indices de position au rang k après entrelacement et avant entrelacement est nécessairement multiple du motif de taille p.

La loi d'entrelacement d'un algorithme RP est donnée par :

$$I(k) = \left[s + kd\right]_K \text{ avec } k = \left\{0,....,K-1\right\}, \ d = \left|I(k+1) - I(k)\right|$$

L'opération $[X]_K$ correspond à l'opération modulo K appliquée sur X et représente donc le reste de la division de X par K, soit :

$$[X]_K = X - E(\frac{X}{K}) \cdot K \text{ avec E}(z) : \text{partie entière de z.}$$

L'algorithme impose de manière restrictive que K et d soient premiers entre eux. Par conséquent, seules certaines valeurs de d sont admises pour une taille K donnée et aucune valeur de d ne peut correspondre à la taille d'un motif car celle-ci est nécessairement un sous multiple de K. Cependant, une analyse de différentes réalisations de l'algorithme montre que si d est choisi tel que K soit multiple de d-1 alors il existe des configurations pour lesquelles un motif de taille p est préservé. Dans ces cas, la quantité d-1 doit être multiple de p. Ceci se traduit par la relation :

$$K = n \times (d-1) = n \times m \times p \qquad (2)$$

Dans le cas par exemple où K=60, les valeurs de d telles que K soit multiple de d-1 avec d et K premiers entre eux sont pour une dispersion supérieure à 10: d=11, d=13 et d=31.

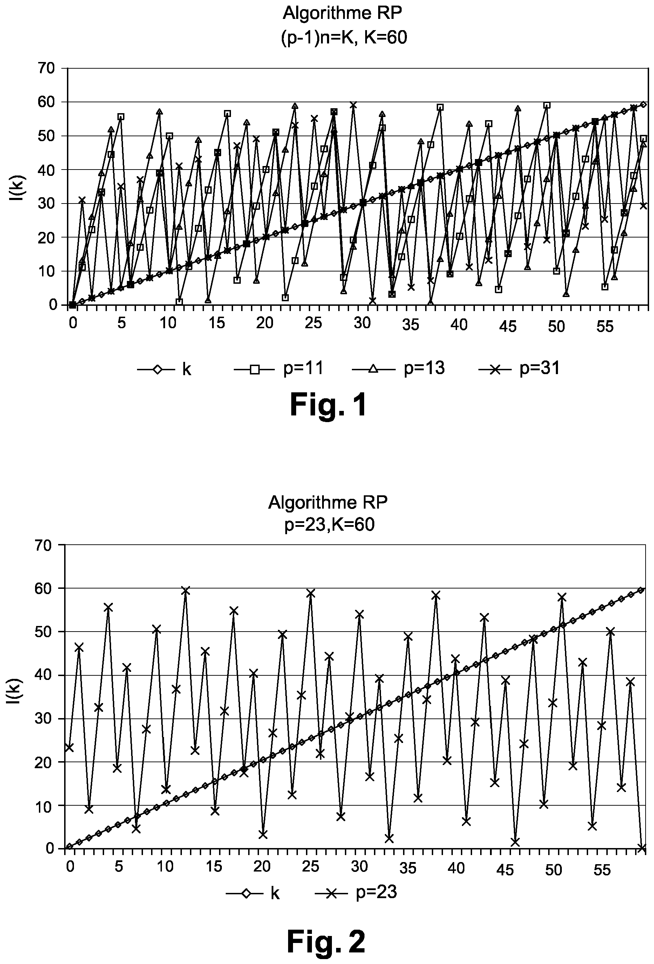

Les lois d'entrelacement RP associées à ces trois valeurs de d pour K=60 sont représentées figure 1. Pour chacun de ces cas, différents motifs de taille p vérifiant l'équation (2) peuvent être préservés. Ainsi, pour d=13, il est possible de préserver un motif de taille p={3, 6, 12}. Pour d=31, il est possible de préserver un motif de taille p={3, 5, 6, 10}. L'observation des lois d'entrelacement montre qu'une périodicité désavantageuse apparaît lorsque la dispersion d augmente. En outre, le nombre de données non entrelacées, c'est-à-dire les données pour lesquelles I(k)=k, s'accroît avec d.

Ainsi, un algorithme RP permet effectivement sous certaines conditions de préserver un motif de taille p et de fixer une dispersion d des données mais les valeurs p et d doivent être faibles pour limiter les structures périodiques et pour limiter le nombre de données non entrelacées à l'issue de l'entrelacement.

Si d-1 n'est pas sous-multiple de K alors un algorithme RP ne permet pas de préserver de manière systématique un motif de taille p, avec K multiple de p. Ceci est illustré par l'exemple suivant au regard de la figure 2 : K=60 et d=23 (d-1=22 n'est pas un sous multiple de K). Soit un motif de taille p=3, choisi de manière arbitraire. Le tableau 1 en Annexe 1 donne la quantité R'(k) correspondant à un motif de taille p= 3, une valeur de d=23, une valeur de K=60 et la loi d'entrelacement de la technique RP.

$$R'(k) = \frac{I(k) - k}{3} \quad \forall k = \left\{0,....,59\right\}$$

R'(k) prenant ses valeurs dans l'espace des réels et non dans l'espace des entiers relatifs il n'y a pas de préservation systématique d'un motif.

De manière avantageuse, la préservation d'un motif par un algorithme RP permet de traiter simultanément dans une chaîne de transmission l'entrelacement destiné aux effets à moyenne échelle et l'entrelacement destiné aux effets à petite échelle (turbo-codes, entrelacement au sein d'un symbole OFDM) et permet par conséquent d'optimiser de manière globale le système de transmission. Toutefois, la préservation d'un motif par un algorithme RP nécessite au moins que le paramètre p soit premier avec K ce qui peut être jugé très contraignant.

Aussi, le problème technique à résoudre par l'objet de la présente invention est de proposer un procédé d'entrelacement bloc de taille K préservant un motif qui permette de traiter simultanément dans une chaîne de transmission l'entrelacement destiné aux effets à moyenne échelle et l'entrelacement destiné aux effets à petite échelle (turbo-codes, entrelacement au sein d'un symbole OFDM) et qui permette par conséquent d'optimiser de manière globale le système de transmission et, qui soit moins contraignant que la méthode RP connue.

Une solution au problème technique posé consiste, selon la présente invention, en ce que ledit procédé d'entrelacement bloc de taille K à N itérations d'indice j, N étant supérieur ou égal à 1, de données numériques indicées par une variable $k = \{0, ...., K\text{-}1\}$, pour positionner des données numériques d'entrée X dans une séquence de sortie composée de données numériques de sortie Y selon un ordre déterminé par une loi d'entrelacement $I^{(j)}(k)$ telle que $Y(k) = X(I^{(j)}(k))$, comprend au moins :

- une première étape de calcul d'une valeur intermédiaire $I_0^{(j)}(k)$, cette valeur intermédiaire $I_0^{(j)}(k)$ étant le résultat, pour la première itération, j=1, d'une première fonction algébrique $f_0(a,b)$, modulo K, à deux variables a et b, appliquée aux indices k d'entrée, a=b=k, et pour chaque itération j suivante, j=2 à N, de la même fonction algébrique $f_0(a,b)$ appliquée aux indices k d'entrée et à une valeur de sortie $I^{(j\text{-}1)}(k)$ obtenue lors de l'itération précédente,
- une deuxième étape de calcul de la valeur de sortie $I^{(j)}(k)$, cette valeur de sortie $I^{(j)}(k)$ étant le résultat, pour une itération j donnée, d'une seconde fonction algébrique $f_1(a,b)$, modulo K, à deux variables a et b, appliquée aux indices k d'entrée et à la valeur intermédiaire $I_0^{(j)}(k)$ calculée lors de la même itération j, a=k et b= $I_0^{(j)}(k)$.

La première fonction algébrique $f_0(a,b)$ et la seconde fonction algébrique $f_1(a,b)$ sont liées entre elles de telle manière que , à chaque itération j, la différence entre l'indice de position de la donnée entrelacée et son rang dans la séquence entrelacée est le produit modulo K d'un paramètre p, dépendant de la taille d'un motif à préserver, et d'une somme entre un paramètre $\alpha$ entier naturel pouvant varier de 0 à $K / p$ et un multiple de la valeur intermédiaire.

En outre, l'invention a pour objet un dispositif d'entrelacement bloc de taille K à N itérations d'indice j, N étant supérieur ou égal à 1, de données numériques d'entrée indicées par une variable $k = \{0, ...., K\text{-}1\}$. Ledit dispositif comprend :

- N cellules de base I à deux entrées et une sortie, telles que chaque cellule de base I est formée de deux cellules élémentaires $I_0$ et $I_1$ qui comportent chacune deux entrées et une sortie, la sortie de la cellule de base I correspondant à la sortie de la cellule élémentaire $I_1$, les deux entrées de la cellule de base I correspondant aux deux entrées de la cellule élémentaire $I_0$, la sortie de la cellule élémentaire $I_0$ correspondant à une première entrée de la cellule élémentaire $I_1$, la seconde entrée de la cellule élémentaire $I_1$ étant reliée à une première entrée de la cellule élémentaire $I_0$ qui correspond à une première entrée de la cellule de base I.

Les deux entrées de la première cellule de base I sont reliées entre elles et correspondent à l'indice k. La sortie de chaque cellule de base I est reliée à la seconde entrée de la cellule de base I de l'itération suivante. Les premières entrées des cellules de base I sont reliées entre elles.

Ainsi, un entrelacement selon l'invention permet de générer, via une structure 'turbo', une loi d'entrelacement de type bloc décrit par une combinaison de fonctions algébriques.

Le procédé d'entrelacement met en oeuvre une structure 'turbo' qui possède deux entrées et une sortie. En effet, à l'issue de chaque itération j, la loi d'entrelacement $I^{(j)}(k)$ en sortie de l'entrelaceur est modifiée suivant une séquence d'entrée formée par les indices de position des données avant entrelacement (typiquement une rampe) et suivant une séquence entrelacée (qui fournit la position des données après entrelacement) issue de l'itération précédente du même algorithme d'entrelacement.

Le procédé et le dispositif d'entrelacement conformes à l'invention résolvent le problème posé. En effet, la loi d'entrelacement $I^{(j)}(k)$ est telle que l'équation (1) est satisfaite et ce, quelles que soient l'itération j, les valeurs de k, p, q et K. La taille p du motif est paramétrable, il s'agit d'un des paramètres de l'entrelaceur.

La loi d'entrelacement selon l'invention dépend de quatre paramètres :

- K, la taille du bloc à entrelacer,
- p, qui dépend de la taille d'un motif à préserver,
- q, qui ajoute un degré de liberté dans l'ajustement de la loi d'entrelacement,
- j, le nombre d'itérations.

Ainsi, l'invention permet de préserver un motif de taille p qui correspond à p flux de données multiplexées.

Le paramètre p peut être choisi comme un multiple d'un paramètre $p_i$ correspondant à un motif élémentaire ou peut avantageusement résulter de la combinaison de plusieurs motifs élémentaires ($\Pi p_i = p$) à préserver. Le motif de répartition élémentaire est assimilable à un multiplexage de p flux de données (systèmes multivoies, MIMO). Ce multiplexage peut être réel ou virtuel ou bien être associé à une opération de codage qui confère des propriétés différentes aux bits dans un train binaire de taille p avant modulation. Il peut correspondre à un motif fixé par l'utilisateur destiné à optimiser les performances globales du système de transmission via un ordonnancement spécifique des données à l'émission spécifié avant ou après l'opération d'entrelacement. Ainsi, un entrelacement selon l'invention peut permettre de préserver des solutions optimales de codage (espace-temps, codage binaire à symbole, contrainte externe associée à un codeur turbo) et d'ordonnancement des données (issues d'un multiplexage par exemple) qui précèdent ou succèdent l'entrelacement. De manière préférentielle, p est déterminé soit en relation avec une optimisation de l'algorithme con-

$$\Delta I_{eff}^{(j)}(s) = Min_{k, k \in S} \left| I^{(j)}(k+s) - I^{(j)}(k) \right|$$

sistant à augmenter la dispersion ⟨formule⟩ suivant un critère donné pour une itération j donnée, soit en fonction d'une contrainte externe, typiquement d'optimisation, imposée par d'autres modules de traitement du système de transmission.

La loi mathématique qui fixe la dispersion entre deux données successives et plus généralement entre deux données séparées de s-1 données après entrelacement dépend de trois paramètres : la taille p du motif à préserver, un paramètre q et le nombre d'itérations mises en oeuvre dans la structure turbo de l'invention. Cette dispersion est donnée par une fonction algébrique.

La dispersion se calcule à l'aide des propriétés fondamentales d'une opération modulo K appliquée sur le polynôme $Pj,s(k) = \Delta I^{(j)}(s)$ décrivant la dispersion entre deux données séparées par s-1 données relié au nombre d'itérations j de l'algorithme de base I.

$$Pj,s(k) = I^{(j)}(k+s) - I^{(j)}(k) \text{ avec } s < K \tag{3}$$

Pour une itération j fixée, l'expression algébrique de l'algorithme génère une structure pseudo-périodique des données entrelacées. Ceci permet de représenter les données entrelacées suivant deux dimensions, dans un plan X-Y et de fournir deux valeurs de dispersion selon que l'on considère l'axe X ou l'axe Y. L'axe Y est utilisé pour représenter la dispersion entre deux données successives $\Delta y = \Delta_{eff}I^{(j)}(s=1)$ et l'axe X pour représenter la dispersion entre deux données séparées de $s_1 - 1$ données, $\Delta x = \Delta_{eff}I^{(j)}(s = s1)$, $s_1$ correspond à la pseudo période de la loi d'entrelacement. Par convention, la pseudo période correspond à la longueur d'une sous séquence $S_1$ (à un échantillon près) pendant laquelle la dispersion $\Delta y$ est constante et égale à $\Delta_{eff}I^{(j)}(s = 1)$. La valeur du paramètre $s_1$ dépend de la valeur de p choisie ainsi que de la dispersion associée $\Delta_{eff}I^{(j)}(s = 1)$ pour l'itération j. Cette structure pseudo périodique est exploitée pour optimiser l'opération d'entrelacement suivant une contrainte externe. Les contraintes externes sont typiquement liées au milieu de transmission et au tramage des données qui optimisent par ailleurs d'autres traitements du système de transmission (motif de répartition des données dans un mot de code, mapping, etc...). L'optimisation de l'opération d'entrelacement consiste à répartir les données entrelacées suivant un agencement spécifique. Selon une réalisation particulière, la répartition des bits codés dans des cellules QAM peut être optimisée en tenant compte de cette structure pseudo périodique. Les paramètres p et q de l'entrelaceur selon l'invention peuvent être judicieusement ajustés de telle sorte que les bits de même poids entre des cellules QAM proches aient une dispersion maximale tout en assurant au sein de chaque cellule QAM une dispersion optimisée entre bits de poids différents.

La structure 'turbo' de l'entrelaceur à l'émission exploite conjointement, pour des itérations supérieures à 1, le motif de la séquence entrelacée de l'itération précédente et les indices de position de la séquence d'origine pour générer un motif d'entrelacement propre. Cette propriété permet d'adapter dynamiquement, en sélectionnant la bonne itération, la loi d'entrelacement et donc la séquence entrelacée de sortie en fonction des propriétés ou des évolutions du support de transmission. L'ajustement et la détermination optimale des paramètres de l'algorithme d'entrelacement permettent donc de modifier conjointement :

- la dispersion $\Delta_{eff}I^{(j)}(s)$ entre deux données successives sur le flux global des données, s=1,
- la dispersion $\Delta_{eff}I^{(j)}(s)$ des données issues d'un même flux i i={1, ...p}, s=p.
- la dispersion $\Delta_{eff}I^{(j)}(s)$ entre deux données distantes de L-1 données où L est fixé par une contrainte externe, s=L. Cette contrainte peut être :

  - la répartition des bits lors de l'opération de codage binaire à symbole.
  - la mise en forme spécifique des données pour la transmission.

La structure pseudo périodique de l'entrelacement selon l'invention permet :

- d'assurer une distance maximale entre les indices de position associés à des données de même poids dans des symboles après une opération de codage binaire à symbole suivie d'une opération de modulation numérique,
- un ordonnancement spécifique des données pour transmettre les données sur le support physique.

Cette structure pseudo périodique confère une structure multidimensionnelle au motif d'entrelacement selon l'invention et s'avère moins complexe dans la mise en oeuvre qu'une structure d'entrelacement appliquée sur chaque branche d'un système multivoies.

Selon un mode de réalisation préférée, la première fonction algébrique $f_0(a,b)$ a pour expression

$$f_0\left(a,b\right)=\left[-a-pb\right]_K \tag{4}$$

et la seconde fonction algébrique $f_1(a,b)$ a pour expression

$$f_1\left(a,b\right)=\left[\alpha p+a+qpb\right]_K. \tag{5}$$

La donnée intermédiaire $I_0$ s'exprime alors à l'issue de la première itération sous la forme

$$I_o^{(1)}(k)=f_0\left(k,k\right)=\left[-k-pk\right]_K \tag{6}$$

et à l'issue de chaque itération suivante sous la forme :

$$I_0^{(j)}(k)=f_0\left(k,I^{(j-1)}(k)\right)=\left[-k-p\cdot I^{(j-1)}(k)\right]_K \tag{7}$$

La donnée entrelacée de sortie $I^{(j)}(k)$ s'exprime à l'issue de chaque itération sous la forme

$$I^{(j)}(k)=I_1^{(j)}\left(k\right)=f_1\left(k,I_0^{(j)}\left(k\right)\right)=\left[\alpha p+k+q\cdot p\cdot I_0^{(j)}\left(k\right)\right]_K \tag{8}$$

avec q et $\alpha$ des paramètres typiquement entiers naturels, $\alpha$ pouvant varier de 0 à $K/p$.

Etant donné que l'entrée b respective des deux fonctions algébriques $f_0$ et $f_1$ est alimentée respectivement par des calculs issus de l'itération précédente et par la valeur intermédiaire $I_0$ de la même itération, alors les deux entrées a et b ne sont pas des variables indépendantes. $I_0$ et $I_1$ ne dépendent par conséquent que de la variable k, indice de position des données dans la séquence d'entrée.

L'invention décrite ici concerne un procédé et un dispositif d'entrelacement. Selon une implémentation préférée, les étapes du procédé sont déterminées par les instructions d'un programme d'entrelacement incorporé dans un circuit électronique telle une puce elle-même pouvant être disposée dans un dispositif électronique tel un émetteur. Le procédé d'entrelacement selon l'invention peut tout aussi bien être mis en oeuvre lorsque ce programme est chargé dans un organe de calcul tel un processeur ou équivalent dont le fonctionnement est alors commandé par l'exécution du programme.

En conséquence, l'invention s'applique également à un programme d'ordinateur, notamment un programme d'ordinateur sur ou dans un support d'informations, adapté à mettre en oeuvre l'invention. Ce programme peut utiliser n'importe quel langage de programmation, et être sous la forme de code source, code objet, ou de code intermédiaire entre code source et code objet tel que dans une forme partiellement compilée, ou dans n'importe quelle autre forme souhaitable pour implémenter un procédé selon l'invention.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette (floppy disc) ou un disque dur.

Alternativement, le support d'informations peut être un circuit intégré dans lequel le programme est incorporé, le circuit étant adapté pour exécuter ou pour être utilisé dans l'exécution du procédé en question.

D'autre part, le programme d'entrelacement peut être traduit en une forme transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

D'autres caractéristiques et avantages de l'invention apparaîtront lors de la description qui suit faite en regard de figures annexées données à titre d'exemples non limitatifs.

La figure 1 est la représentation graphique d'une séquence d'entrelacement obtenue avec un algorithme RP de l'art antérieur pour des valeurs différentes de p, p étant premier avec K taille du bloc.

La figure 2 est la représentation graphique d'une séquence d'entrelacement obtenue avec un algorithme RP de l'art antérieur pour une valeur de p telle que p-1 ne soit pas sous multiple de K.

La figure 3 est un schéma illustrant une opération d'entrelacement.

La figure 4 est un organigramme d'un procédé d'entrelacement selon l'invention.

Les figures 5, 6a et 6b représentent schématiquement le principe de base de la structure d'un entrelaceur selon l'invention.

La figure 7 est une représentation graphique d'une séquence d'entrelacement obtenue dans un cas particulier d'optimisation d'un entrelacement selon l'invention.

La figure 8 est un schéma illustrant une mise en oeuvre d'un entrelacement selon l'invention dans un système d'émission/réception.

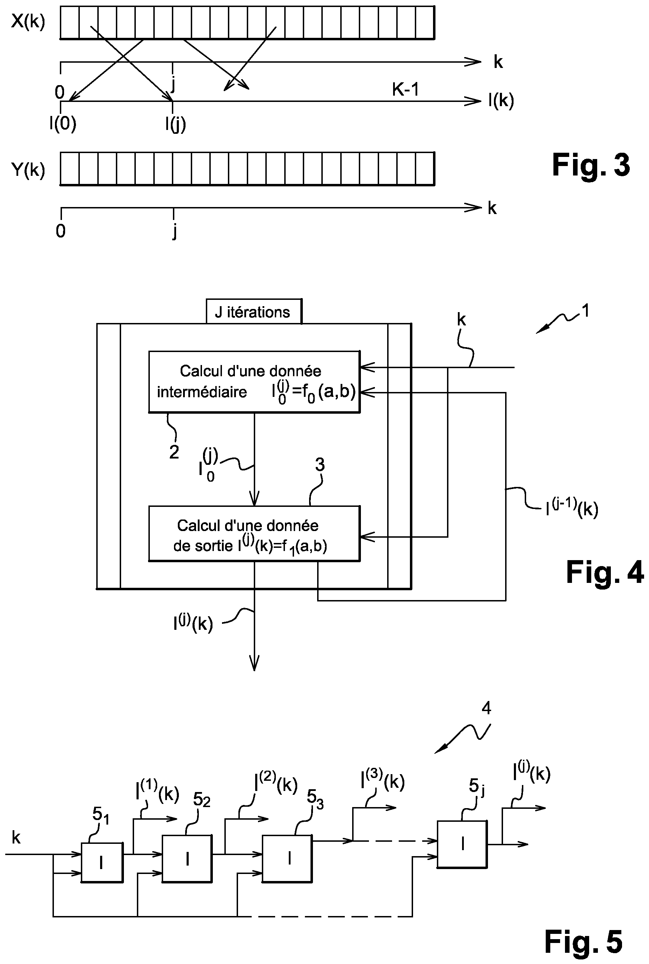

La figure 3 illustre la notion d'entrelacement. Elle représente une séquence de données X(k) en entrée d'un entrelaceur de loi d'entrelacement I(k). La séquence des données en sortie est notée Y(k). Cette séquence de sortie est liée à la séquence d'entrée par la relation :

$$Y(k) = X(I(k)) \text{ avec } k = \{0, ..., K-1\} \text{ et } I(k) = \{0, ..., K-1\}.$$

La figure 4 représente un organigramme d'une réalisation particulière d'un procédé d'entrelacement selon l'invention.

Un procédé 1 d'entrelacement à N itérations selon l'invention effectue l'entrelacement sous contraintes d'un bloc de taille K de données numériques d'entrée indicées par une variable $k = \{0, ..., K - 1\}$, en préservant un motif de taille p ou sous multiple de p.

Dans une première étape 2, le procédé 1 calcule une valeur intermédiaire $I_0^{(j)}(k)$. Cette valeur intermédiaire $I_0^{(j)}(k)$ est le résultat d'une première fonction algébrique $f_0(a,b)$ modulo K à deux entrées a et b.

La première fonction algébrique est, selon le mode préféré, telle que $f_0(a,b)=[-a-bp]_K$ avec p un paramètre lié au motif ce qui donne : $I_0^{(j)}(k)=[-a-bp]_K$.

Pour la première itération, les entrées a et b sont reliées entre elles et correspondent aux indices k d'entrée, a=b=k, soit pour ce mode préféré :

$$I_o^{(1)}(k) = [-k - kp]_K \text{ avec } k = \{0, ...., K-1\}. \tag{9}$$

Pour les N-1 itérations suivantes, cette valeur intermédiaire $I_0^{(j)}(k)$ est le résultat de la même fonction algébrique $f_0(a,b)$ appliquée aux indices k d'entrée et à une donnée $I^{(j-1)}(k)$ de sortie obtenue lors de l'itération précédente, telle que $I_0^{(j)}(k) = f_0(a,b)$ avec a=k et $b = I^{(j-1)}(k)$, soit pour le mode préféré :

$$I_0^{(j)}(k) = \left[ -k - I^{(j-1)}(k) \times p \right]_K. \tag{10}$$

Dans une deuxième étape 3, le procédé 1 calcule une donnée entrelacée de sortie $I^{(j)}(k)$. Cette donnée entrelacée de sortie $I^{(j)}(k)$ est le résultat d'une seconde fonction algébrique $f_1(a,b)$ des indices k d'entrée et de la valeur intermédiaire $I_0^{(j)}(k)$, telle que :

$$I^{(j)}(k) = f_1(k, I_0^{(j)}(k)). \tag{11}$$

La seconde fonction algébrique est, selon le mode préféré, telle que $f_1(a,b)=[\alpha p+a+q\cdot p\cdot b]_K$ ce qui donne pour $I^{(j)}(k)$:

$$I^{(j)}(k) = f_1(a,b) = \left[\alpha p + k + q \cdot p \cdot I_0^{(j)}(k)\right]_K \qquad (12)$$

avec $\alpha$ un entier naturel variant de 0 à $K/p$, q un paramètre entier naturel. Dans un cas particulier du mode préféré $\alpha = K/p - 1$. Dans ce cas :

$$I^{(j)}(k) = \left[K - p + k + q \cdot p \cdot I_0^{(j)}(k)\right]_K .$$

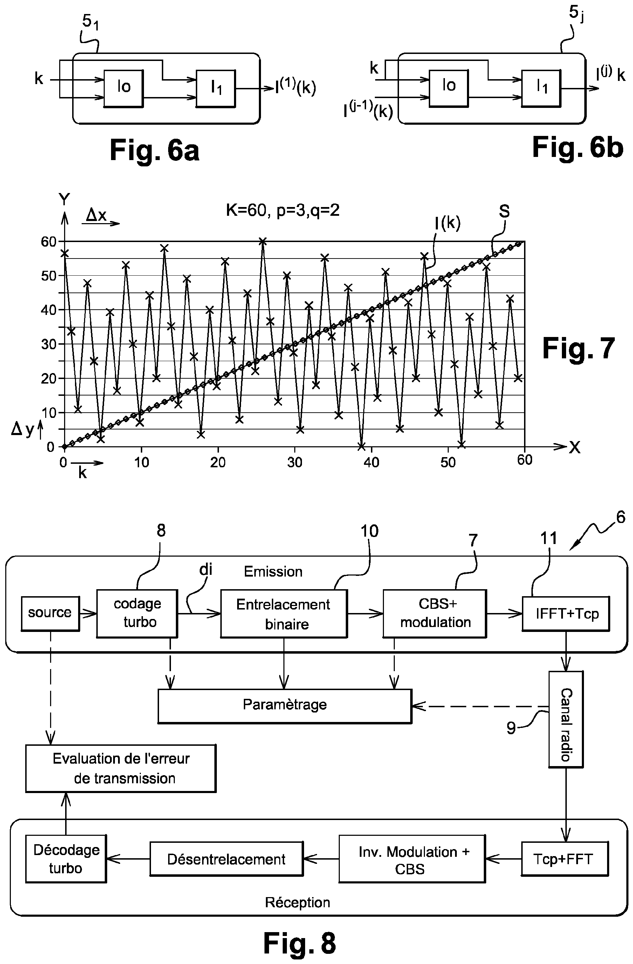

Les figures 5, 6a et 6b représentent schématiquement le principe de base de la structure d'un entrelaceur selon l'invention adapté pour mettre en oeuvre un procédé d'entrelacement selon l'invention.

La figure 5 est une représentation schématique d'un entrelaceur 4 à N itérations, c'est-à-dire à N cellules $5_1$, $5_2$, $5_3$, $5_j$ de base I.

Les figures 6a et 6b sont chacune une loupe d'une cellule de base notée I dans le schéma de la figure 5 ; la cellule $5_1$ de base I de la figure 6a, de la figure 6b respectivement, correspond à la première itération, respectivement aux itérations j différentes de un.

La sortie de la jième cellule $5_j$ de base, qui correspond à la jième itération, fournit une séquence entrelacée qui s'exprime sous la forme $I^{(j)}(k)$.

Chaque cellule $5_1$, $5_2$, $5_3$, $5_j$ de base I de l'entrelaceur présente la même structure : deux entrées, une sortie et deux cellules élémentaires, notées $I_0$ et $I_1$ sur les figures 6a et 6b. Chaque cellule élémentaire $I_0$, $I_1$, comporte deux entrées et une sortie. Les deux entrées de la cellule élémentaire $I_0$ correspondent aux deux entrées de la cellule de base I à laquelle elle appartient, la sortie de la cellule élémentaire $I_1$ correspond à la sortie de la cellule de base I à laquelle elle appartient. La sortie de la cellule élémentaire $I_0$ est reliée à une entrée de la cellule élémentaire $I_1$. La seconde entrée de la cellule élémentaire $I_1$ est reliée à une entrée de la cellule de base I ; cette entrée de la cellule de base I étant alimentée par les indices k à entrelacer qui se présentent généralement sous la forme d'une rampe de 0 à K-1. La seconde entrée de la cellule de base I est reliée à la sortie de la cellule de base I précédente, sauf pour la première cellule $5_1$ de base, figure 6a, pour laquelle les deux entrées sont reliées entre elles.

Cette représentation est schématique car la structure turbo peut-être réalisée différemment avec, par exemple, une seule cellule de base I et un ensemble de re-bouclage entre la sortie et les entrées, cet ensemble étant adapté pour mettre en oeuvre un procédé selon l'invention.

L'entrelacement de base I(k) effectué par une cellule $5_1$, $5_2$, $5_3$, $5_j$ de base I résulte d'une structure hiérarchique formée des deux cellules élémentaires $I_0$ et $I_1$. La cellule élémentaire $I_0$ comprend un moyen de calcul adapté pour calculer la première fonction algébrique $f_0$ modulo K à deux entrées a, b avec a=k. La cellule élémentaire $I_1$ comprend un moyen de calcul adapté pour calculer la seconde fonction algébrique $f_1$ modulo K à deux entrées a et b, avec a=k .

Ceci se traduit par les relations suivantes pour le mode préféré :

$$I_0(k) = f_o(k,b) = \left[-k - bp\right]_K \text{ avec } k = \{0,....,K-1\} , \qquad (13)$$

$$I_1(k) = f_1(k,b) = \left[\alpha p + k + b \cdot p \cdot q\right]_K \text{ avec } k = \{0,....,K-1\} \qquad (14)$$

Et pour la première cellule $5_1$ de base I, qui correspond à la première itération, j=1, les entrées a et b de la cellule élémentaire $I_0$ sont reliées entre elles, par conséquent :

$$I_0^{(1)}(k) = f_0(k,k) = \left[-k - kp\right]_K \text{ avec } k = \{0,....,K-1\} . \qquad (15)$$

La structure hiérarchique de la cellule $5_1$, $5_2$, $5_3$, $5_j$ de base I implique que l'entrée b de la cellule élémentaire $I_1$ est alimentée par la sortie de la cellule élémentaire $I_0$ ; la cellule $5_1$, $5_2$, $5_3$, $5_j$ de base I dispose elle-même d'une structure turbo.

$$I_1(k) = f_1(k, I_0(k)) = \left[\alpha p + k + I_0(k) \cdot p \cdot q\right]_K \text{ avec } k = \{0,....,K-1\} . \qquad (16)$$

Selon le mode préféré, l'entrelacement obtenu par une cellule $5_1$, $5_2$, $5_3$, $5_j$ de base I est le résultat d'une fonction algébrique f :

$$I(k) = f(p, q, k, K) = [\alpha p + k + I_0(k) \cdot p \cdot q]_K \text{ avec } k = \{0, ...., K-1\} . \tag{17}$$

Soit pour la première cellule $5_1$ de base I ($1^{\text{ère}}$ itération), en remplaçant $I_0(k)$ par son expression :

$$I^{(1)}(k) = \left[ \alpha p + k + p \cdot q \cdot [-k - k \cdot p]_K \right]_K \text{ avec } k = \{0, ...., K-1\} . \tag{18}$$

L'entrelacement I(k) obtenu par une cellule de base I est intégré dans une structure turbo, par conséquent pour l'itération 2 :

$$I_0^{(2)}(k) = \left[ -k - p \times I^{(1)}(k) \right]_K \text{ avec } k = \{0, ...., K-1\}$$

et la loi d'entrelacement est donnée par :

$$I^{(2)}(k) = \left[ \alpha p + k + I_0^{(2)}(k) \cdot p \cdot q \right]_K \text{ avec } k = \{0, ...., K-1\}$$

$$I^{(2)}(k) = \left[ \alpha p + k + p \cdot q \cdot \left[ -k - p \cdot I^{(1)}(k) \right]_K \right]_K$$

et plus généralement, pour l'itération j :

$$I_0^{(j)}(k) = \left[ -k - p \cdot I^{(j-1)}(k) \right]_K \quad k = \{0, ...., K-1\} \tag{19}$$

et la loi d'entrelacement pour l'itération j est donnée par :

$$I^{(j)}(k) = \left[ \alpha p + k + p \cdot q \cdot I_0^{(j)}(k) \right]_K \quad k = \{0, ..K-1\}$$

$$I^{(j)}(k) = \left[ \alpha p + k + p \cdot q \cdot \left[ -k - p \cdot I^{(j-1)}(k) \right]_K \right]_K \quad k = \{0, ..K-1\} \tag{20}$$

Cette loi $I^{(j)}(k)$ préserve bien un motif de taille p car elle vérifie la relation (1) :
$I^{(j)}(k) - k = Q(k) \times p$ avec $k = \{0, ...., K-1\}$, où Q(k) est une fonction dans l'espace des entiers relatifs Z telle que quel que soit k on ait $Q(k) \times p < K$.
En effet :

$$I^{(j)}(k) - k = \left[ \alpha p + p \cdot q \cdot I_0^{(j)}(k) \right]_K \quad k = \{0, ..K-1\}$$

$$I^{(j)}(k) - k = p \left[ \alpha + q \cdot \left[ -k - p \cdot I^{(j-1)}(k) \right]_K \right]_K \quad k = \{0, ..K-1\} \tag{21}$$

La valeur Q(k) est bien une valeur entière : la relation (1) est vérifiée quelles que soient l'itération j, la valeur de k et la valeur de q.

Avantageusement, l'invention permet de spécifier la dispersion entre des données d'entrée successives. En effet, la distance entre deux données successives et plus généralement la dispersion entre données distantes de s-1 données est estimée algébriquement en développant les équations de la loi d'entrelacement et en tenant compte des propriétés de l'opération modulo qui reposent sur les propriétés suivantes :

$$\left[a + b\right]_N = \left[\left[a\right]_N + \left[b\right]_N\right]_N$$

$$\left[a \cdot b\right]_N = \left[\left[a\right]_N \cdot \left[b\right]_N\right]_N$$

Pour l'itération j, on désigne par $\Delta_{eff}I^{(j)}(s = 1)$ la dispersion entre deux données successives et par $\Delta I^{(j)}(k)$ la différence entre $I^{(j)}(k+1)$ et $I^{(j)}(k)$. Ce dernier résultat peut être négatif et comporte deux valeurs dues à la structure pseudo-périodique du motif d'entrelacement qui introduit une discontinuité dans le motif d'entrelacement. A l'issue de l'opération d'entrelacement de la jième itération, l'écart de position entre deux données lues dans la séquence d'entrée et placées en sortie de l'entrelaceur est décrit mathématiquement par deux nombres $\Delta I^{(j)}(k)$ et $\Delta I_c^{(j)}(k)$. La dispersion $\Delta_{eff}I^{(j)}(s = 1)$ correspond au minimum de la valeur absolue des deux écarts précédents. Ce minimum est constant sur une fenêtre d'observation de taille égale à $L^{(j)}(p,q)$ à une donnée près.

Pour l'itération j=1, les deux écarts sont donnés par :

$$\Delta I^{(1)}(k) = I^{(1)}\left(k + 1\right) - I^{(1)}\left(k\right)$$

$$\Delta I_c^{(1)}(k) = K - \left|\Delta^{(1)}I(k)\right|$$

Et la dispersion est donnée par la relation :

$$\Delta_{eff}I^{(1)}(s = 1) = Min\left\{\left|I^{(1)}(k+1) - I^{(1)}(k)\right|, K - \left|I^{(1)}(k+1) - I^{(1)}(k)\right|\right\}$$

Le mode d'estimation de l'écart $\Delta I(k)$ repose sur le développement des équations de la relation d'entrelacement. L'écart $\Delta I(k)$ se déduit des expressions de $I(k)$ et de $I(k+1)$ et de la soustraction de ces deux éléments.

Selon le mode préféré, la dispersion s'exprime sous la forme suivante, pour l'itération j=1 :

$$\Delta_{eff}I^{(1)}\left(s = 1\right) = Min\left\{\left|\Delta I^{(1)}(k)\right|, K - \left|\Delta I^{(1)}(k)\right|\right\} = Min\left\{\left|\left[1 - q \cdot p(1 + p)\right]_K\right|, K - \left[1 - q \cdot p(1 + p)\right]_K\right\}$$

Car :

$$I^{(1)}(k) = \left[\alpha p + k + qp\left[-k - pk\right]_K\right]_K \quad k = \left\{0, ...., K - 1\right\}$$

$$I^{(1)}(k + 1) = \left[\alpha p + k + 1 + qp\left[-(k + 1) - p(k + 1)\right]_K\right]_K$$

$$\Delta I^{(1)}(k) = \left[1 - qp(p + 1)\right]_K$$

Pour l'itération j=2 :

$$\Delta_{eff}I^{(2)}(s = 1) = Min\left\{\left|\Delta I^{(2)}(k)\right|, K - \left|\Delta I^{(2)}(k)\right|\right\} = Min\left\{\left|\left[1 - qp(1 + p\Delta I^{(1)}(k))\right]_K\right|, K - \left[1 - qp(1 + p\Delta I^{(1)}(k))\right]_K\right\}$$

car :

$$I^{(2)}(k) = \left[\alpha p + k + qpI_0^{(2)}(k)\right]_K = \left[\alpha p + k - qp\left[k + pI^{(1)}(k)\right]_K\right]_K \text{ avec } k = \{0,....,K-1\}$$

$$\Delta I^{(2)}(k) = I^{(2)}(k+1) - I^{(2)}(k) = \left[1 - qp(1 + p\Delta I^{(1)}(k))\right]_K$$

Et ainsi pour l'itération j :

$$\Delta_{eff}I^{(j)}(s=1) = Min\left\{\left|\Delta I^{(j)}(k)\right|, K - \left|\Delta I^{(j)}(k)\right|\right\} = Min\left\{\left|\left[1 - qp(1 + p\Delta I^{(j-1)}(k))\right]_K\right|, K - \left[\left[1 - qp(1 + p\Delta I^{(j-1)}(k))\right]_K\right]\right\}$$

car

$$I^{(j)}(k) = \left[\alpha p + k + qpI_0^{(j)}(k)\right]_K = \left[\alpha p + k + qp\left[-k - pI^{(j-1)}(k)\right]_K\right]_K \quad k = \{0,....,K-1\}$$

$$\Delta I^{(j)}(k) = \left[1 - qp(1 + p\Delta I^{(j-1)}(k))\right]_K$$

La taille de la fenêtre d'observation pendant laquelle l'écart $\Delta I^{(j)}(k)$ est constant s'exprime, à une donnée près, sous la forme :

$$L^{(1)}(p,q) = E\left\{\frac{K}{\Delta_{eff}I^{(1)}(s=1)}\right\} \quad \text{pour l'itération 1, avec E\{Z\} : partie entière de Z.}$$

$$L^{(j)}(p,q) = E\left\{\frac{K}{\left|\Delta_{eff}I^{(j)}(s=1)\right|}\right\} \quad \text{pour l'itération j}$$

Plus généralement, la dispersion sur le flux global entre deux données séparées de s-1 données s'exprime, à l'issue de l'itération j, sous la forme :

$$\Delta_{eff}I^{(j)}(s) = Min\left\{\left|\left[s - q \cdot p(s + pP_{j,s}(k))\right]_K\right|, K - \left[\left[s - qp(s + pP_{j,s}(k))\right]_K\right]\right\}$$

avec

$$P_{j,s}(k) = I^{(j)}(k+s) - I^{(j)}(k) = \left[s - q \cdot p \cdot (s + p \cdot P_{j-1,s}(k))\right]_K$$

$$P_{1,s}(k) = \left[s - qp \times s(p+1)\right]_K$$

Les expressions précédentes permettent de calculer l'écart $\Delta I^{(j)}(k)$ et la dispersion $\Delta_{eff}I^{(j)}(s=1)$ entre deux données successives et plus généralement entre deux données séparées de s-1 données à l'issue de toute itération. La dispersion peut par conséquent être calculée pour différentes valeurs de s et le nombre d'itérations N peut être déterminé en lui donnant la valeur de l'itération j pour laquelle ces différentes dispersions sont chacune supérieure ou égale à une dispersion imposée pour chaque valeur de s.

Cette propriété algébrique de l'algorithme d'entrelacement selon l'invention, qui a une structure pseudo périodique, induit une dispersion à structure bi-dimensionnelle qui permet d'optimiser l'opération d'entrelacement suivant plusieurs contraintes externes. Cette optimisation de l'opération d'entrelacement permet ainsi de préserver les contraintes de multiplexage de données imposées par l'optimisation des traitements en aval et en amont de l'opération d'entrelacement.

Ainsi, une optimisation de l'algorithme est réalisée grâce aux propriétés algébriques de l'entrelacement selon l'invention qui sont modifiées par le nombre d'itérations de mise en oeuvre d'une cellule I de base et le choix des valeurs de p et q.

Une procédure d'optimisation pour un multiplexage optimale des données avant leur mise en forme consiste à :

- étape 1)Choisir p et q pour une taille d'entrelacement K, sachant que K est multiple de p.
- étape 2)Estimer la dispersion $\Delta_{eff}I^{(j)}(s = 1)$, la taille $L^{(j)}(k)$ et la dispersion maximale sur une pseudo-période : $\Delta_{eff}I^{(j)}(s = L^{(j)}(p,q)-1)=(L^{(j)}(p,q)-1)\cdot\Delta_{eff}I^{(j)}(s = 1)$.
- étape 3)Pour au moins une contrainte externe, évaluer la dispersion $\Delta_{eff}I^{(j)}(s)$ pour différentes valeurs de j. entre données distantes de s-1 données en relation avec cette contrainte externe qui fixe la valeur du paramètre entier s.
- Etape 4)Sélectionner l'itération j qui fournit la plus grande dispersion entre données distantes de s-1 données dans les cas où s est fixé par une contrainte externe et $s = L^{(j)}(p,q)-1$. S'il existe plusieurs itérations fournissant des valeurs identiques avec une loi d'entrelacement différente, sélectionner l'itération qui fournit la plus grande dispersion entre données successives.
- reproduire les étapes 1) 2) 3) si les valeurs de p et q ne sont pas optimales vis-à-vis d'au moins un seuil So(s) fixé par l'utilisateur. Si une contrainte extérieure impose p, alors seule la valeur q est modifiée.

Les exemples suivants auxquels correspondent la figure 7 et le tableau 2 figurant en Annexe 2 d'une part et les tableaux 3 et 4 d'autre part figurant en Annexe 2 permettent d'illustrer une telle opération d'optimisation.

Soit K la taille du bloc à entrelacer. Il s'agit de définir p, q et le nombre d'itérations à prendre en compte pour optimiser la répartition des données entrelacées suivant une mise en forme imposée par un système de transmission. A cette fin, la fonction I(k) est représentée dans le plan X-Y avec le motif d'entrelacement suivant l'axe Y et les indices k suivant l'axe X. Cette représentation, figure 7, décrit l'ordre suivant lequel les données doivent être lues en sortie de l'entrelaceur. L'ordonnée fournit la position de la donnée dans la séquence d'entrée tandis que l'axe des abscisses indique à quelle position la donnée est placée dans la séquence de sortie. La procédure d'optimisation consiste à répartir les données suivant cette structure tout en tenant compte d'une contrainte externe, un codage binaire à symbole selon l'exemple, pour ajuster le motif. L'ajout sur la figure 7 de la séquence S non entrelacée permet de constater que toutes les données sont entrelacées car aucune ne vérifie la relation I(k)=k.

Pour une même loi d'entrelacement, le tableau 2 figurant en Annexe 2 donne la répartition des bits entrelacés dans différentes cellules QAM dans le cas d'un entrelacement bloc de taille K=60 de paramètres p=3 et q=2. Ce cas suppose que doit être préservé un motif initial de bits de taille 3 imposé par une contrainte extérieure. Une cellule x-QAM est composée de m=Log2(x) bits regroupés en deux ensembles de m/2 bits. Ainsi, une cellule 16-QAM est composée des bits b3, b2, b1 et b0. Les bits de même poids sont b0 et b2 d'une part, et b3 et b1 d'autre part. Une cellule 64-QAM est composée des bits b5, b4, b3, b2, b1, b0. Les bits de même poids sont b0 et b3, b1 et b4, b2 et b5. La dispersion entre deux bits successifs correspond à $\Delta_{eff}I^{(j)}(s = 1)$, la dispersion entre deux bits de même poids séparés de m-1 bits appartenant à deux cellules x-QAM adjacentes correspond à $\Delta I_{eff}(s = m)$. Le paramétrage de l'entrelacement selon l'invention consiste à choisir l'itération j qui permet d'obtenir conjointement la plus forte dispersion d'une part entre bits de même poids appartenant à des cellules x-QAM adjacentes, $\Delta I_{eff}(s = m)$ car cette dernière impacte la décorrélation des symboles reçus en réception et améliore l'efficacité du circuit de décision et d'autre part entre bits successifs, $\Delta_{eff}I(s = 1)$.

Selon le tableau 2, on constate que pour la 64-QAM, les itérations 1 et 3 fournissent la même dispersion entre bits de même poids, $\Delta I_{eff}(6) = 18$. L'optimisation consiste à sélectionner parmi les itération un et trois celle qui conduit à la dispersion la plus grande entre deux bits successifs $\Delta_{eff}I^{(j)}(s = 1)$, j={1,3} : la 1ère itération. En ce qui concerne la modulation 16-QAM, l'optimisation consiste à sélectionner l'itération 1 qui conduit à la dispersion la plus grande entre bits de même poids associés à des cellules QAM adjacentes, $\Delta I_{eff}(4) = 28$ et qui conduit à la dispersion la plus grande entre bits successifs $\Delta_{eff}I(s = 1) = 23$ .

Le tableau 2 révèle que les valeurs de p et q choisies sont plus appropriées au mapping des bits entrelacés codés dans des cellules 16-QAM qu'à la répartition des bits entrelacés codés dans des cellules 64-QAM : la dispersion des bits de même poids est plus élevée entre des cellules 16-QAM. Ainsi, l'utilisation du motif est optimale pour un mapping en 16-QAM avec une seule itération.

Les tableaux 3 et 4 illustrent une procédure d'optimisation au cours de laquelle sont reproduites les étapes 1), 2), 3) pour rechercher une valeur optimale de p. Dans le cas d'une modulation 64-QAM, le tableau 3 révèle que la valeur optimale de p est 6 ou 12 pour une itération égale à 2 car elle permet d'obtenir la plus forte dispersion d'une part entre bits de même poids appartenant à des cellules QAM différentes, $\Delta I_{eff}(6) = 30$, d'autre part entre deux bits successifs $\Delta_{eff}I(1) = 25$.

Dans le cas d'une modulation 16-QAM, le tableau 4 révèle que la valeur optimale de p est 3 ou 6 pour une itération égale à 1 car elle permet d'obtenir la plus forte dispersion d'une part entre bits de même poids associés à des cellules QAM différentes, $\Delta I_{eff}(4) = 28$ et d'autre part entre deux bits successifs $\Delta_{eff}I(k) = 23$.

L'optimisation se traduit par une amélioration des performances radio, soit une réduction du Taux d'Erreur Binaire en réception, et par voie de conséquence par un accroissement de la qualité de service (QoS) et de la capacité globale du système de transmission.

La figure 8 permet d'illustrer un exemple de mise en oeuvre de l'invention appliqué à un système 6 de transmission radio. L'algorithme selon l'invention est mis en oeuvre pour optimiser les performances du système 6 de transmission radio vis-à-vis du taux d'erreur binaire en exploitant la structure pseudo-périodique de l'entrelaceur. La configuration choisie est une configuration SISO. Pour cette configuration, l'entrelacement mis en oeuvre est destiné à réduire l'impact du fading de Rayleigh qui induit en réception, après décodage, des bursts d'erreurs. La structure est optimisée pour assurer une dispersion maximale entre les bits de même poids de cellules 7 64-QAM différentes et entre deux bits successifs sur canaux multi trajets. La dispersion entre cellules 64-QAM différentes tient conjointement compte de la dispersion entre cellules QAM adjacentes $\Delta_{eff}(s = 6)$ et de la dispersion maximale sur une période $L^{(j)}(p,q)$ entre cellules QAM $\Delta_{eff}I(s = L^{(j)}(p,q)-1)$.Une taille $L^{(j)}(p,q)$ telle que $L^{(j)}(p,q)=mn+m/2$ où m représente le nombre de bits par symbole et n un entier à ajuster, est optimale pour garantir une dispersion moyenne maximale entre bits de même poids associées à des cellules x-QAM différentes($x=2^m$). Par ailleurs, l'algorithme a été également utilisé pour générer la matrice interne à des turbo-codes 8 FOCTC intégrés dans la chaîne de transmission numérique.

Le système 6 de transmission est de type multi porteuses et défini dans la bande des 2-3 GHz. La canalisation du spectre est de 5 MHz et la bande occupée par les sous-porteuses de 3,456 MHz. Cette configuration est analogue à l'attribution de trois porteuses 'DECT' pour assurer la transmission, elle est également proche de celle de l'UMTS.

Les modèles de canaux multi trajets considérés pour les simulations du système correspondent aux modèles de canaux validés par l'organisme ITU-R, International Telecommunication Union-Radio Study Groups, 'Guidelines for Evaluation of Radio Transmission Technologies for IMT-2000/FPLMTS', FPLMTS.REVAL, Question ITU-R, Document 8/29-E, 10 june 1996, pour simuler un environnement de type urbain. L'exemple correspond à une situation de déploiement de type microcellulaire dont la couverture radioélectrique n'excède pas 500 m. Il s'agit du modèle de canal en tapped delay line 'Vehicular A'.

Les paramètres OFDM sont ajustés en fonction des caractéristiques du canal 9 de propagation et d'une perte d'efficacité spectrale introduite par l'intervalle de garde de $\Delta ef = 0,34$ dB. Ce dimensionnement tient compte des modèles de canaux 'Pedestrian B' et 'Vehicular A' pour la taille de l'intervalle de garde $T_{CP}$ ($T_{CP} > \tau_{max}$) avec $\tau_{max}$ représentant l'excursion temporelle des retards du profil de puissance moyen du canal de propagation. Le tableau 5 en Annexe 3 donne les paramètres OFDM associés au système 6 de transmission ainsi que les caractéristiques du codeur 8 turbo FOCTC.

La matrice interne aux turbo-codes 8 est générée de façon à ce que les données soient entrelacées conformément à un procédé d'entrelacement selon l'invention. Le motif généré a une taille de vingt qui est multiple de cinq égale à la longueur de contrainte du code élémentaire convolutif récursif. Le motif répond bien à la contrainte imposée par les codes FOCTC pour lesquels un état du codeur à 'zéro' en fin de treillis impose un motif élémentaire égale à cinq. La dispersion est égale à 601, la valeur de q égale à 2 et la pseudo-période égale à L(20,2)=2.

Un second 10 entrelacement obtenu par un procédé selon l'invention est effectué sur les données $d_i$ codées avant le codage 7 binaire à symbole et la modulation 11 des sous-porteuses. L'invention est utilisée dans ce contexte pour corriger les bursts d'erreurs associés aux évanouissements rapides du canal 9 de propagation tout en assurant une dispersion moyenne maximale entre les bits de même poids de cellules 64-QAM différentes et les bits successifs du train de bits codés. La taille de l'entrelacement, c'est-à-dire la taille K de l'entrelacement bloc, est ajustée pour une excursion Doppler de 206 Hz. Cette excursion correspond à une fenêtre spatiale d'une longueur d'onde, soit à approximativement 97 symboles OFDM, c'est-à-dire 103680 bits codés.

L'optimisation géométrique de l'entrelacement repose sur la recherche d'une dispersion maximale moyenne entre bits de même poids ainsi qu'entre bits de poids différents dans une cellule 64-QAM. Compte tenu de la structure pseudo périodique de la loi d'entrelacement, ceci revient à définir p et q tels que la fenêtre L, pendant laquelle l'écart entre bits est constant, est de la forme L =6n+3. Cette condition assure une dispersion maximale entre les bits de poids identiques.

Le tableau 6 de l'annexe 3 donne la dispersion obtenue pour différentes valeurs p multiples de la taille du motif à préserver qui est de six (le chiffre six vient de $2^6$, taille des cellules 64-QAM). D'après le tableau, les modes 2 et 4 sont optimaux vis-à-vis du mapping. Les performances en termes de TEB font apparaître des gains de l'ordre de 1.5 dB par rapport à l'algorithme RP lorsque le nombre de branches est de la forme 6n+3 pour les modes 2 et 4 de réalisation du tableau

L'invention s'applique aussi bien aux systèmes de transmission multiporteuse que monoporteuse dès lors que les données sont mises en paquets. Pour des systèmes de communications radiocellulaires et tous les systèmes basés sur une architecture réseau de type WPAN, WLAN et WMAN, l'invention peut être exploitée pour mixer les données inter-utilisateurs et intra-utilisateur avant émission sur le support physique.

Un domaine d'application qui peut s'avérer particulièrement intéressant est celui pour lequel la longueur d'onde associée à la fréquence porteuse est élevée (métrique, deca-métrique, et autres) et peu adaptée au déploiement d'un système multivoies de type MIMO. La structure multi dimensionnelle de l'algorithme d'entrelacement selon l'invention permet d'introduire virtuellement un système multivoies tout en s'affranchissant d'une structure réelle à encombrement élevé pour assurer une décorrélation entre les sources élémentaires (l'espacement entre antennes doit être supérieur à λ/2). Ceci peut s'appliquer tout aussi bien pour des terminaux mobiles que l'on souhaite de faible taille que pour des structures fixes nécessitant une longueur d'onde importante pour de la transmission à grande distance (applications pour la radiodiffusion ionosphérique).

En particulier, l'invention peut être mise en oeuvre dans les situations suivantes et répondre à des contraintes spécifiques.

Une première utilisation particulière de l'invention correspond à une mise en oeuvre pour des turbo-codeurs FOCTC en bloc de taille K. En effet, un entrelacement selon l'invention permet de répondre à des contraintes associées à un tel codeur qui imposent que $I(k)-k= A(k)*M$, où M est la longueur de contrainte du code élémentaire de type convolutif récursif formant la structure du turbo-code et $A(k)$ une suite d'entiers telle que $A(k)*M<K-1$ quel que soit l'indice k, k= {0, ...K-1} et K : taille du bloc à entrelacer.

Une deuxième utilisation particulière de l'invention correspond à une mise en oeuvre pour l'Optimisation globale d'un système de transmission combinant deux entrelaceurs bloc, un 'court' et un 'long'. La mise en oeuvre d'un entrelacement selon l'invention pour l'entrelaceur long permet avantageusement de préserver la loi d'entrelacement de l'entrelaceur court ; il suffit de prendre p égale à la profondeur de l'entrelaceur court.

Une troisième utilisation particulière de l'invention correspond à une mise en oeuvre pour une correction de la corrélation introduite par le support de transmission. Cette corrélation se traduit par un nombre de données corrélées sur une fenêtre d'observation T. Une mesure de la corrélation du canal peut être effectuée à partir d'une estimation du canal réalisée par un des modules en réception. La connaissance du nombre de données corrélées permet de déterminer une dispersion cible. L'ajustement des paramètres de l'algorithme d'entrelacement selon l'invention permet d'obtenir une dispersion au moins égale à la dispersion cible.

Une quatrième utilisation particulière de l'invention correspond à une mise en oeuvre pour une optimisation conjointe d'un entrelacement binaire et d'une opération de codage binaire à symbole pour la modulation des signaux à transmettre. L'optimisation du codage binaire à symbole consiste à exploiter la structure 2D de l'algorithme pour augmenter la dispersion entre deux bits de même poids avant l'opération de codage binaire à symbole et la dispersion des bits au sein de chaque symbole.

Une cinquième utilisation particulière de l'invention correspond à une mise en oeuvre pour une optimisation conjointe des performances sur la couche physique et du tramage des données sur la couche 'protocoles de transmission' pour la réduction de l'interférence inter-utilisateurs.

L'entrelacement selon l'invention préserve un motif initial de répartition des données de taille p assimilable à un multiplexage de p flux de données. Par ailleurs la dispersion entre deux données successives ou bien entre deux données successives d'un même flux peut être calculée par une fonction algébrique. On peut utiliser cette propriété pour améliorer conjointement les performances de la couche MAC et de la couche physique.

La maîtrise de la procédure d'entrelacement à la fois en terme de dispersion et de multiplexage des données qui précède la transmission des données sur le support physique est fondamentale pour l'optimisation des performances non seulement sur la couche physique mais également au niveau de la couche MAC du système. Les gains se traduisent par une réduction de la puissance nécessaire pour assurer un débit dans une technologie (radio ou filaire) donnée ou bien par un accroissement de la couverture du système associée à une qualité de service pour une puissance d'émission fixée. Par exemple, l'invention permet d'ajuster et d'optimiser l'entrelacement en fonction de la répartition des utilisateurs dans une trame pour une transmission en mode paquet. L'invention permet une optimisation conjointe de la capacité et des performances sur le support de transmission.

ANNEXE 1

Tableau 1 : loi d'entrelacement pour la technique RP avec K=60 et p=23, calcul de R'

| k | I(k) | R'(k) | k | I(k) | R'(k) |
|---|------|-------|---|------|-------|
| 0 | 0 | 0 | 30 | 30 | 0 |
| 1 | 23 | 7.33 | 31 | 53 | 7.33 |
| 2 | 46 | 14.7 | 32 | 16 | -5.33 |

(suite)

| k | l(k) | R'(k) | k | l(k) | R'(k) |
|---|------|-------|---|------|-------|
| 3 | 9 | 2 | 33 | 39 | 2 |
| 4 | 32 | 9.33 | 34 | 2 | -10.7 |
| 5 | 55 | 16.7 | 35 | 25 | -3.33 |
| 6 | 18 | 4 | 36 | 48 | 4 |
| 7 | 41 | 11.3 | 37 | 11 | -8.67 |
| 8 | 4 | -1.33 | 38 | 34 | -1.33 |
| 9 | 27 | 6 | 39 | 57 | 6 |
| 10 | 50 | 13.3 | 40 | 20 | -6.67 |
| 11 | 13 | 0.67 | 41 | 43 | 0.67 |
| 12 | 36 | 8 | 42 | 6 | -12 |
| 13 | 59 | 15.3 | 43 | 29 | -4.67 |
| 14 | 22 | 2.67 | 44 | 52 | 2.67 |
| 15 | 45 | 10 | 45 | 15 | -10 |
| 16 | 8 | -2.67 | 46 | 38 | -2.67 |
| 17 | 31 | 4.67 | 47 | 1 | -15.3 |
| 18 | 54 | 12 | 48 | 24 | -8 |
| 19 | 17 | -0.67 | 49 | 47 | -0.67 |
| 20 | 40 | 6.67 | 50 | 10 | -13.3 |
| 21 | 3 | -6 | 51 | 33 | -6 |
| 22 | 26 | 1.33 | 52 | 56 | 1.33 |
| 23 | 49 | 8.67 | 53 | 19 | -11.3 |
| 24 | 12 | -4 | 54 | 42 | -4 |
| 25 | 35 | 3.33 | 55 | 5 | -16.7 |
| 26 | 58 | 10.7 | 56 | 28 | -9.33 |
| 27 | 21 | -2 | 57 | 51 | -2 |
| 28 | 44 | 5.33 | 58 | 14 | -14.7 |
| 29 | 7 | -7.33 | 59 | 37 | -7.33 |

ANNEXE 2

**Tableau 2 : Dispersion des données entrelacées**

| | $\Delta_{eff}l^{(j)}$ ($s = 1$) | $L^{(j)}(k)$ | 64-QAM $\Delta_{eff}l^{(j)}(k, s = 6)$ | 16-QAM $\Delta_{eff}l^{(j)}(k, s = 4)$ |
|---|---|---|---|---|
| Itération 1 | 23 | 3 | 18 | 28 |
| Itération 2 | 11 | 5 | 6 | 16 |
| Itération 3 | 13 | 5 | 18 | 18 |

Tableau 3 : Dispersion pour différentes valeurs de p, q=2 et une modulation 64-QAM

| K | P | K/p | $\Delta_{eff}I^{(j)}(s = 1)$ | | | $L(s=1)$ | | | $\Delta_{eff}I^{(j)}(k,s = 6)$ | | |
|---|---|-----|------|------|------|------|------|------|------|------|------|
|   |   |     | it.1 | It. 2 | It. 3 | it. 1 | It. 2 | It. 3 | it.1 | It. 2 | It. 3 |
| 60 | 3 | 20 | 23 | 11 | 13 | 3 | 5 | 5 | 18 | 6 | 18 |
| 60 | 6 | 10 | 23 | 25 | 11 | 3 | 2 | 5 | 18 | 30 | 6 |
| 60 | 12 | 5 | 11 | 25 | 23 | 5 | 2 | 3 | 6 | 30 | 18 |
| 60 | 15 | 4 | 1 | 1 | 1 | 60 | 60 | 60 | 6 | 6 | 6 |
| 60 | 20 | 3 | 1 | 1 | 1 | 60 | 60 | 60 | 6 | 6 | 6 |

**Tableau 4 : Dispersion pour différentes valeurs de p, q=2 et une modulation 16-QAM**

| K | p | K/p | $\Delta_{eff}I^{(j)}(s = 1)$ | | | $L(s=1)$ | | | $\Delta_{eff}I^{(j)}(k,s = 4)$ | | |
|---|---|-----|------|------|------|------|------|------|------|------|------|
|   |   |     | it.1 | It. 2 | It. 3 | it. 1 | It. 2 | It. 3 | it.1 | It. 2 | It. 3 |
| 60 | 3 | 20 | 23 | 11 | 13 | 3 | 5 | 5 | 28 | 16 | 8 |
| 60 | 6 | 10 | 23 | 25 | 11 | 3 | 2 | 5 | 28 | 20 | 16 |
| 60 | 12 | 5 | 11 | 25 | 23 | 5 | 2 | 3 | 16 | 20 | 28 |
| 60 | 15 | 4 | 1 | 1 | 1 | 60 | 60 | 60 | 4 | 4 | 4 |
| 60 | 20 | 3 | 1 | 1 | 1 | 60 | 60 | 60 | 4 | 4 | 4 |
| 60 | 30 | 2 | 1 | 1 | 1 | 60 | 60 | 60 | 4 | 4 | 4 |

ANNEXE 3

**Tableau 5 : paramètres OFDM associés au système de transmission**

| Paramètres OFDM et codage | Valeur |
|---|---|
| $N_{pm}$: Nombre de sous-porteuses | 177 |
| $\Delta_F$: espacement interporteuse | 19.5 kHz |
| $N_{FFT}$: IFFT/FFT | 256 |
| $T_{CP}$: durée du préfixe cyclique | 4.2 µs |
| $T_{FFT}$: durée du temps symbole utile | 51.2 µs |
| $T_{SYM}$: Durée totale du symbole OFDM | 55.4 µs ($T_{CP}$ + $T_{FFT}$) |
| Fe : fréquence d'échantillonnage | 5 MHz |
| Codage FOCTC , r=1/3 | Polynômes générateurs du code élémentaire RSC (25o, 37o) |
| Matrice d'entrelacement interne aux FOCTC | Invention avec p=20, q=2, $K_{int}$=1440, itération 1 |

**Tableau 6 : Paramètres des matrices d'entrelacement**

| | p | $\Delta I_{eff}(s = 1)$ | $\Delta I_{eff}(s = L)$ | Nbranches L | $\Delta I_{eff}(s = 6)$ |
|---|---|---|---|---|---|
| mode 1 | 6x1440=8640 | 17279 | 6 | 6 | 6 |
| Mode 2 | 240 | 11999 | 4311 | 9 | 71294 |
| Mode 3 | 1440 | 2879 | 36 | 36 | 17274 |
| Mode 4 | 36 | 2663 | 177 | 39 | 15978 |
| RP | 17279 | 173279 | | | |

**Revendications**

1. Procédé (1) d'entrelacement bloc de taille K à N itérations d'indice j, N étant supérieur ou égal à 1, de données numériques indicées par une variable $k = \{0,....,K\text{-}1\}$, pour positionner des données numériques d'entrée X dans une séquence de sortie composée de données numériques de sortie Y selon un ordre déterminé par une loi d'entrelacement $I^{(j)}(k)$ telle que $Y(k)=X(I^{(j)}(k))$, qui comprend au moins :

   - une première étape (2) de calcul d'une valeur intermédiaire $I_0^{(j)}(k)$, cette valeur intermédiaire $I_0^{(j)}(k)$ étant le résultat,

   pour la première itération, j=1, d'une première fonction algébrique $f_0(a,b)$, modulo K, à deux variables a et b, appliquée aux indices k d'entrée, a=b=k, telle que $f_0(a,b)=[-a\text{-}pb]_K$,
   et, dans le cas où N>1, pour chaque itération j suivante, j=2 à N, de la même fonction algébrique $f_0(a,b)$ appliquée aux indices k d'entrée et à une valeur de sortie $I^{(j\text{-}1)}(k)$ obtenue lors de l'itération précédente, a=k et b= $I^{(j\text{-}1)}(k)$,

   - une deuxième étape (3) de calcul de la valeur de sortie $I^{(j)}(k)$, cette valeur de sortie $I^{(j)}(k)$ étant le résultat, pour une itération j donnée, d'une seconde fonction algébrique $f_1(a,b)$, modulo K, à deux variables a et b, appliquée aux indices k d'entrée et à la valeur intermédiaire $I_0^{(j)}(k)$ calculée lors de la même itération j, a=k et b= $I_0^{(j)}(k)$,

   la première fonction algébrique $f_0(a,b)$ et la seconde fonction algébrique $f_1(a,b)$ étant liées entre elles de telle manière que la valeur de sortie $I^{(j)}(k)$ à l'issue de chaque itération j est telle que :

   $$I^{(j)}(k) = \left[ \alpha p + k + q \cdot p \cdot I_0^{(j)}(k) \right]_K$$

   avec q et p des paramètres entiers naturels, p étant un sous-multiple de K choisi tel que sa valeur permet de préserver un motif, préserver un motif signifiant que l'ordonnancement de p flux de données multiplexées, comprenant chacun une partition de K/p données, est conservé après l'opération d'entrelacement, $[X]_K$ signifiant X modulo K et avec $\alpha$ un paramètre entier naturel tel que $\alpha \in \{0....,K / p\}$.

2. Procédé (1) d'entrelacement bloc de taille K à N itérations d'indice j, selon la revendication 1, dans lequel $\alpha$ a pour valeur K/p-1.

3. Procédé (1) d'entrelacement bloc de taille K à N itérations d'indice j, selon l'une des revendications 1 à 2, dans lequel p dépend de la taille d'un motif à préserver déterminée par une contrainte extérieure.

4. Procédé (1) d'entrelacement bloc de taille K à N itérations selon la revendication précédente, dans lequel la contrainte extérieure tient compte de la répartition des bits des symboles issus d'un codage binaire à symbole.

5. Procédé (1) d'entrelacement bloc de taille K à N itérations selon l'une des revendications précédentes, comprenant en outre, pour une itération j donnée, une étape de calcul d'un écart après entrelacement entre deux données numériques d'entrée séparés de s-1 données, X(k) et X(k+s), cet écart étant donné par la relation $P_{j,s}(k)=I^{(j)}(k + s)\text{-}I^{(j)}(k)=[s\text{-}q\cdot p\cdot(s + p\cdot P_{j\text{-}1,s}(k))]_K$ calculée de manière itérative, s étant strictement inférieur à K et avec $P_{1,s}(k)=[s\text{-}q\cdot p\cdot s(1 + p)]_K$, avec q un paramètre entier naturel et $[X]_K$ signifiant X modulo K.

6. Procédé (1) d'entrelacement bloc de taille K à N itérations selon la revendication précédente, dans lequel une valeur de dispersion $\Delta_{eff}I^{(j)}(s)$ est déterminée à partir de l'écart $P_{j,s}(k)=I^{(j)}(k + s)\text{-}I^{(j)}(k)$ au moyen de la relation $\Delta_{eff}I^{(j)}(s)=Min\{|P_{j,s}(k)|,K\text{-}|P_{j,s}(k)|\}$, pour au moins une valeur déterminée de s supérieure ou égale à un, et dans lequel l'itération j sélectionnée est telle qu'à l'issue de cette itération j chaque dispersion $\Delta_{eff}I^{(j)}(s)$ est supérieure ou égale à une valeur déterminée.

7. Dispositif (4) d'entrelacement bloc de taille K de données numériques d'entrée indicées par une variable k, $k=\{0, ...., K\text{-}1\}$, effectuant l'entrelacement d'un bloc de données suivant une loi d'entrelacement déterminée $I^{(j)}(k)$, de paramètres p et q déterminés, comprenant N itérations d'une cellule de base I d'indice j formant une structure dite turbo à deux entrées et une sortie telle que pour j=1 les deux entrées de la cellule I sont reliées entre elles et telle que, dans le cas où N>1, pour j>1 une entrée de la cellule I est reliée à la sortie de la cellule I de l'itération j-1, chaque cellule I étant à structure turbo composée d'une première cellule élémentaire $I_0$ et d'une deuxième cellule élémentaire, comprenant un moyen de calcul adapté pour calculer :

- une valeur intermédiaire $I_0^{(j)}(k)$ qui correspond à la sortie de la première cellule élémentaire de la cellule de base I de l'itération j, cette valeur intermédiaire $I_0^{(j)}(k)$ étant le résultat,

pour la première itération, j=1, d'une première fonction algébrique $f_0(a,b)$, modulo K, à deux variables a et b, appliquée aux indices k d'entrée, a=b=k, telle que $f_0(a,b)=[-a-pb]_K$,
et, dans le cas où N>1, pour chaque itération j suivante, j=2 à N, de la même fonction algébrique $f_0(a,b)$ appliquée aux indices k d'entrée et à une valeur de sortie $I^{(j-1)}(k)$ obtenue lors de l'itération précédente, a=k et b=$I^{(j-1)}(k)$, et

- la valeur de sortie $I^{(j)}(k)$ qui correspond à la sortie de la deuxième cellule élémentaire et de la cellule de base I de l'itération j, cette valeur de sortie $I^{(j)}(k)$ étant le résultat, pour une itération j donnée, d'une seconde fonction algébrique $f_1(a,b)$, modulo K, à deux variables a et b, appliquée aux indices k d'entrée et à la valeur intermédiaire

$I_0^{(j)}(k)$ calculée lors de la même itération j, a=k et b= $I_0^{(j)}(k)$
la première fonction algébrique $f_0(a,b)$ et la seconde fonction algébrique $f_1(a,b)$ étant liées entre elles de telle manière que la valeur de sortie $I^{(j)}(k)$ à l'issue de chaque itération j est telle que :

$$I^{(j)}(k) = \left[ \alpha p + k + q \cdot p \cdot I_0^{(j)}(k) \right]_K$$ avec q et p des paramètres entiers naturels, p étant un sous-multiple de K tel que sa valeur permet de préserver un motif, préserver un motif signifiant que l'ordonnancement de p flux de données multiplexées, comprenant chacun une partition de K/p données, est conservé après l'opération d'entrelacement, $[X]_K$ signifiant X modulo K et avec $\alpha$ un paramètre entier naturel tel que $\alpha \in \{0,....,K/p\}$.

8. Signal numérique destiné à être utilisé dans un dispositif (4) électronique d'entrelacement bloc de taille K à N itérations d'indice j, N étant supérieur ou égal à 1, de données numériques indicées par une variable $k=\{0,....,K-1\}$, pour positionner des données numériques d'entrée X dans une séquence de sortie composée de données numériques de sortie Y selon un ordre déterminé par une loi d'entrelacement $I^{(j)}(k)$ telle que $Y(k)=X(I^{(j)}(k))$, le signal numérique comprenant au moins des codes pour l'exécution par le dispositif (4) électronique d'au moins les étapes suivantes :

- une première étape (2) de calcul d'une valeur intermédiaire $I_0^{(j)}(k)$, cette valeur intermédiaire $I_0^{(j)}(k)$ étant le résultat,

pour la première itération, j=1, d'une première fonction algébrique $f_0(a,b)$, modulo K, à deux variables a et b, appliquée aux indices k d'entrée, a=b=k, telle que $f_0(a,b)=[-a-pb]_K$, et,
dans le cas où N>1, pour chaque itération j suivante, j=2 à N, de la même fonction algébrique $f_0(a,b)$ appliquée aux indices k d'entrée et à une valeur de sortie $I^{(j-1)}(k)$ obtenue lors de l'itération précédente, a=k et b=$I^{(j-1)}(k)$,

- une deuxième étape (3) de calcul de la valeur de sortie $I^{(j)}(k)$, cette valeur de sortie $I^{(j)}(k)$ étant le résultat, pour une itération j donnée, d'une seconde fonction algébrique $f_1(a,b)$, modulo K, à deux variables a et b, appliquée aux indices k d'entrée et à la valeur intermédiaire $I_0^{(j)}(k)$ calculée lors de la même itération j, a=k et b= $I_0^{(j)}(k)$,
la première fonction algébrique $f_0(a,b)$ et la seconde fonction algébrique $f_1(a,b)$ étant liées entre elles de telle manière que la valeur de sortie $I^{(j)}(k)$ à l'issue de chaque itération j est telle que :

$$I^{(j)}(k) = \left[ \alpha p + k + q \cdot p \cdot I_0^{(j)}(k) \right]_K$$ avec q et p des paramètres entiers naturel, p étant un sous-multiple de K tel que sa valeur permet de préserver un motif, préserver un motif signifiant que l'ordonnancement de p flux de données multiplexées, comprenant chacun une partition de K/p données, est conservé après l'opération d'entrelacement, $[X]_K$ signifiant X modulo K et avec $\alpha$ un paramètre entier naturel tel que $\alpha \in \{0, ...., K/p\}$.

9. Support d'informations comportant des instructions de programme adaptées à la mise en oeuvre d'un procédé (1) d'entrelacement bloc de taille K à N itérations d'indice j, N étant supérieur ou égal à 1, de données numériques d'entrée indicées par une variable k = {0,....,K-1} selon l'une quelconque des revendications 1 à 6, lorsque ledit programme est chargé et exécuté dans un dispositif (4) électronique.

**Patentansprüche**

1. Verfahren (1) zur Blockverschachtelung der Größe K mit N Iterationen mit dem Index j, wobei N größer als oder gleich 1 ist, von digitalen Daten, die durch eine Variable k={0, ..., K-1} indiziert sind, um digitale Eingangsdaten X in einer Ausgangssequenz, die aus digitalen Ausgangsdaten Y besteht, in einer durch ein Verschachtelungsgesetz $I^{(j)}(k)$ bestimmten Reihenfolge derart zu positionieren, dass gilt $Y(k)=X(I^{(j)}(k))$, das mindestens aufweist:

   - einen ersten Schritt (2) der Berechnung eines Zwischenwerts $I_0^{(j)}(k)$, wobei dieser Zwischenwert $I_0^{(j)}(k)$ das Ergebnis,
   für die erste Iteration, j=1, einer ersten algebraischen Funktion $f_0(a,b)$, Modulo K, mit zwei Variablen a und b, ist, die auf die Eingangsindices k, a=b=k, angewendet wird, so dass $f_0(a,b)=[-a-pb]_K$,
   und, wenn N>1, für jede folgende Iteration j, j=2 bis N, der gleichen algebraischen Funktion $f_0(a,b)$ ist, die auf die Eingangsindices k und auf einen Ausgangswert $I^{(j-1)}(k)$ angewendet wird, der bei der vorhergehenden Iteration, a=k und $b=I^{(j-1)}(k)$, erhalten wurde,
   - einen zweiten Schritt (3) der Berechnung des Ausgangswerts $I^{(j)}(k)$, wobei dieser Ausgangswert $I^{(j)}(k)$ das Ergebnis, für eine gegebene Iteration j, einer zweiten algebraischen Funktion $f_1(a,b)$, Modulo K, mit zwei Variablen a und b, ist, die auf die Eingangsindices k und auf den Zwischenwert $I_0^{(j)}(k)$ angewendet wird, der bei der gleichen Iteration j, a=k und $b=I_0^{(j)}(k)$ berechnet wird,
   wobei die erste algebraische Funktion $f_0(a,b)$ und die zweite algebraische Funktion $f_1(a,b)$ so miteinander verbunden sind, dass der Ausgangswert $I^{(j)}(k)$ am Ende jeder Iteration j so ist, dass gilt:

   $$I^{(j)}(k) = [\alpha p + k + q \cdot p \cdot I_0^{(j)}(k)]_K,$$ wobei q und p ganzzahlige natürliche Parameter sind, wobei p ein Teilvielfaches von K ist, das so ausgewählt ist, dass sein Wert das Bewahren eines Musters gestattet, wobei das Bewahren eines Musters anzeigt, dass die Anordnung von p gemultiplexten Datenströmen, jeweils umfassend eine Teilung von K/p Daten, nach der Verschachtelungsoperation bewahrt wird, wobei $[X]_K$ X Modulo K bedeutet und wobei $\alpha$ ein ganzzahliger natürlicher Parameter ist, so dass gilt $\alpha \in \{0,...,K/p\}$.

2. Verfahren (1) zur Blockverschachtelung der Größe K mit N Iterationen mit dem Index j, nach Anspruch 1, bei dem a den Wert K/p-1 hat.

3. Verfahren (1) zur Blockverschachtelung der Größe K mit N Iterationen mit dem Index j, nach einem der Ansprüche 1 bis 2, bei dem p von der Größe eines zu bewahrenden Musters abhängt, welche Größe durch eine externe Bedingung bestimmt wird.

4. Verfahren (1) zur Blockverschachtelung der Größe K mit N Iterationen nach dem vorhergehenden Anspruch, bei dem die externe Bedingung die Verteilung der Bits der Symbole berücksichtigt, die aus einer binären Symbolcodierung stammen.

5. Verfahren (1) zur Blockverschachtelung der Größe K mit N Iterationen nach einem der vorhergehenden Ansprüche, das weiter für eine gegebene Iteration j einen Schritt der Berechnung einer Abweichung nach Verschachtelung zwischen zwei digitalen Eingangsdaten getrennt durch s-1 Daten, X(k) und X(k+s), aufweist, wobei diese Abweichung durch die Beziehung $P_{j,s}(k)=I^{(j)}(k+s)-I^{(j)}(k)=[s-q\cdot p\cdot(s+p\cdot P_{j-l,s}(k))]_K$ gegeben wird, die iterativ berechnet wird, wobei s strikt niedriger ist als K und mit $P_{l,s}(k)=[s-q\cdot p\cdot s(l+p)]_K$, wobei q ein ganzzahliger natürlicher Parameter ist und $[X]_K$ X Modulo K bedeutet.

6. Verfahren (1) zur Blockverschachtelung der Größe K mit N Iterationen nach dem vorhergehenden Anspruch, bei dem ein Dispersionswert $\Delta_{eff}I^{(j)}(s)$ ausgehend von der Abweichung $P_{j,s}(k)=I^{(j)}(k+s)-I^{(j)}(k)$ mittels der Beziehung $\Delta_{eff}I^{(j)}(s)=Min\{|P_{j,s}(k)|,K-|P_{j,s}(k)|\}$ für mindestens einen bestimmten Wert von s größer als oder gleich eins bestimmt wird, und bei dem die ausgewählte Iteration j so ist, dass am Ende dieser Iteration j jede Dispersion $\Delta_{eff}I^{(j)}(s)$ größer als ein oder gleich einem bestimmten Wert ist.

7. Vorrichtung (4) zur Blockverschachtelung der Größe K von digitalen Eingangsdaten, die durch eine Variable k indiziert sind, k={0, ..., K-1}, die die Verschachtelung eines Datenblocks gemäß einem bestimmten Verschachtelungsgesetz $I^{(j)}(k)$ mit bestimmten Parametern p und q umfassend N Iterationen einer Basiszelle I mit dem Index j, die eine als Turbo bezeichnete Struktur mit zwei Eingängen und einem Ausgang bildet, so dass für j=1 die beiden Eingänge der Zelle I miteinander verbunden sind, und so dass, wenn N > 1, für j > 1, ein Eingang der Zelle I mit dem Ausgang der Zelle I der Iteration j-1 verbunden ist, wobei jede Zelle I eine Turbo-Struktur aufweist, bestehend aus einer ersten Elementarzelle $I_0$ und einer zweiten Elementarzelle, umfassend ein Rechenmittel, das geeignet ist, zu berechnen:

- einen Zwischenwert $I_0^{(j)}(k)$, der dem Ausgang der ersten Elementarzelle der Basiszelle I der Iteration j entspricht, wobei dieser Zwischenwert $I_0^{(j)}(k)$ das Ergebnis,
für die erste Iteration, j=1, einer ersten algebraischen Funktion $f_0(a,b)$, Modulo K, mit zwei Variablen a und b, ist, die auf die Eingangsindices k, a=b=k, angewendet wird, so dass gilt $f_0(a,b)=[-\alpha-pb]_K$,
und, wenn N>1, für jede folgende Iteration j, j=2 bis N, der gleichen algebraischen Funktion $f_0(a,b)$ ist, die auf die Eingangsindices k und auf einen Ausgangswert $I^{(j-1)}(k)$ angewendet wird, der bei der vorhergehenden Iteration, a=k und b=$I^{(j-1)}(k)$ erhalten wurde, und
- den Ausgangswert $I^{(j)}(k)$, der dem Ausgang der zweiten Elementarzelle und der Basiszelle I der Iteration j entspricht, wobei dieser Ausgangswert $I^{(j)}(k)$ das Ergebnis, für eine gegebene Iteration j, einer zweiten algebraischen Funktion $f_1(a,b)$, Modulo K, mit zwei Variablen a und b, ist, die auf die Eingangsindices k und auf den Zwischenwert $I_0^{(j)}(k)$ angewendet wird, der bei der gleichen Iteration j, a=k und b=$I_0^{(j)}(k)$, berechnet wird, wobei die erste algebraische Funktion $f_0(a,b)$ und die zweite algebraische Funktion $f_1(a,b)$ so miteinander verbunden sind, dass der Ausgangswert $I^{(j)}(k)$ am Ende jeder Iteration j so ist, dass gilt:

$$I^{(j)}(k) \; = \; [\alpha p + k + q \cdot p \cdot I_0^{(j)}(k)]_K,$$

wobei q und p ganzzahlige natürliche Parameter sind, wobei p ein Teilvielfaches von K ist, so dass sein Wert das Bewahren eines Musters gestattet, wobei das Bewahren eines Musters anzeigt, dass die Anordnung von p gemultiplexten Datenströmen, jeweils umfassend eine Teilung von K/p Daten, nach der Verschachtelungsoperation bewahrt wird, wobei $[X]_K$ X Modulo K bedeutet, und wobei $\alpha$ ein ganzzahliger natürlicher Parameter ist, so dass gilt $\alpha \in \{0,...,K/p\}$.

8. Digitales Signal, das dazu bestimmt ist, in einer elektronischen Vorrichtung (4) zur Blockverschachtelung der Größe K mit N Iterationen mit dem Index j, wobei N größer als oder gleich 1 ist, von digitalen Daten verwendet zu werden, die durch eine Variable k={0, ..., K-1} indiziert sind, um digitale Eingangsdaten X in einer Ausgangssequenz, die aus digitalen Ausgangsdaten Y besteht, in einer durch ein Verschachtelungsgesetz $I^{(j)}(k)$ bestimmten Reihenfolge derart zu positionieren, dass gilt Y(k)=X($I^{(j)}(k)$), wobei das digitale Signal mindestens Codes für die Durchführung mindestens der folgenden Schritte durch die elektronische Vorrichtung (4) aufweist:

- eines ersten Schritts (2) der Berechnung eines Zwischenwerts $I_0^{(j)}(k)$, wobei dieser Zwischenwert $I_0^{(j)}(k)$ das Ergebnis,
für die erste Iteration, j=1, einer ersten algebraischen Funktion $f_0(a,b)$, Modulo K, mit zwei Variablen a und b, ist, die an die Eingangsindices k, a=b=k, angewendet wird, so dass $f_0(a,b)=[-a-pb]_k$, und,
wenn N>1, für jede folgende Iteration j, j=2 bis N, der gleichen algebraischen Funktion $f_0(a,b)$ ist, die auf die Eingangsindices k und auf einen Ausgangswert $I^{(j-1)}(k)$ angewendet wird, der bei der vorhergehenden Iteration, a=k und b=$I^{(j-1)}(k)$, erhalten wurde,
- einen zweiten Schritt (3) der Berechnung des Ausgangswerts $I^{(j)}(k)$, wobei dieser Ausgangswert $I^{(j)}(k)$ für eine gegebene Iteration j das Ergebnis einer zweiten algebraischen Funktion $f_1(a,b)$, Modulo K, mit zwei Variablen a und b, ist, die auf die Eingangsindices k und auf den Zwischenwert $I_0^{(j)}(k)$ angewendet wird, der bei der gleichen Iteration j berechnet wird, a=k und $b=I_0^{(j)}(k)$,

wobei die erste algebraische Funktion $f_0(a,b)$ und die zweite algebraische Funktion $f_1(a,b)$ so miteinander verbunden sind, dass der Ausgangswert $I^{(j)}(k)$ am Ende jeder Iteration j so ist, dass gilt:

$$\mathrm{I^{(j)}(k)} \;=\; [\alpha p + k + q \cdot p \cdot I_0^{(j)}(k)]_K,$$ wobei q und p ganzzahlige natürliche Parameter sind, wobei p ein Teilvielfaches von K ist, so dass sein Wert das Bewahren eines Musters gestattet, wobei das Bewahren eines Musters anzeigt, dass die Anordnung von p gemultiplexten Datenströmen, jeweils umfassend eine Teilung von K/p Daten, nach der Verschachtelungsoperation bewahrt wird, wobei $[X]_K$ X Modulo K bedeutet, und wobei $\alpha$ ein ganzzahliger natürlicher Parameter ist, so dass gilt $\alpha \in \{0,...,K/p\}$.

**9.** Informationsträger, der Programmanweisungen aufweist, die für die Anwendung eines Verfahrens (1) zur Blockverschachtelung der Größe K mit N Iterationen mit dem Index j, wobei N größer als oder gleich 1 ist, von digitalen Eingangsdaten geeignet ist, die durch eine Variable k={0, ..., K-1} indiziert sind, nach einem der Ansprüche 1 bis 6, wenn das Programm in eine elektronische Vorrichtung (4) geladen und ausgeführt wird.

**Claims**

**1.** A block interleaving method (1) with a block size K and with N iterations of index j, N being greater than or equal to 1, for interleaving digital data items indexed by a variable $k = \{0, ..., K\text{-}1\}$ for positioning input digital data items X in an output sequence made up of output digital data items Y in an order determined by an interleaving law $I^{(j)}(k)$ such that $Y(k)=X(I^{(j)}(k))$, which method comprises at least:

a first step (2) of calculating an intermediate value $I_0^{(j)}(k)$ that
for the first iteration, j=1, is the result of applying a first algebraic function $f_0(a, b)$ modulo K with two variables a and b to the input indices k, a=b=k, such that $f_0(a,b)=[-a-pb]_K$,
and, when N>1, for each subsequent iteration j, j=2 to N, is the result of applying the same algebraic function $f_0(a, b)$ to the input indices k and to an output value $I^{(j-1)}(k)$ obtained during the preceding iteration, a=k and b=$I^{(j-1)}(k)$;
a second step (3) of calculating the output value $I^{(j)}(k)$ that, for a given iteration j, is the result of applying a second algebraic function $f_1(a, b)$ modulo K with two variables a and b to the input indices k and to the intermediate

value $I_0^{(j)}(k)$ calculated in the same iteration j, a=k and b=$I_0^{(j)}(k)$;
the first algebraic function $f_0(a, b)$ and the second algebraic function $f_1(a, b)$ being linked together so that the

$$I^{(j)}(k) = \left[ \alpha p + k + q \cdot p \cdot I_0^{(j)}(k) \right]_K$$ with q

output value $I^{(j)}(k)$ output from each iteration j is such that: and p natural integer parameters,
p being a sub-multiple of K chosen such that its value allows a pattern to be preserved, a pattern to be preserved meaning that the order of p multiplexed data streams, each comprising a partition of K/p data items, is preserved after the interleaving operation, $[X]_K$ meaning X modulo K and with $\alpha$ a natural integer parameter such that $\alpha \in \{0, ... , K/p\}$.

**2.** Block interleaving method (1) with a block size K and with N iterations of index j according to Claim 1, wherein $\alpha$ has the value K/p-1.

**3.** Block interleaving method (1) with a block size K and with N iterations of index j according to either of Claims 1 and 2, wherein p depends on the size of a pattern to be preserved, which size is determined by an external constraint.

**4.** Block interleaving method (1) with a block size K and with N iterations according to the preceding claim, wherein the external constraint takes account of the distribution of the bits in symbols resulting from symbol binary coding.

**5.** Block interleaving method (1) with a block size K and with N iterations according to any one of the preceding claims, further including, for a given iteration j, a step of calculating a difference after interleaving between two input digital data items X(k) and X(k+s) separated by s-1 data items, that difference being given by the iteratively calculated equation $P_{j,s}(k)=I^{(j)}(k + s)-I^{(j)}(k)=[s-q\cdot p\cdot(s + p\cdot P_{j-1,s}(k))]_K$, where s is strictly less than K and with $P_{1,s}(k)=[s-q\cdot p\cdot s(1+p)]_K$, q is a natural integer parameter and $[X]_K$ signifies X modulo K.

**6.** Block interleaving method (1) with a block size K and with N iterations according to the preceding claim, wherein a dispersion value $\Delta_{eff}I^{(j)}(s)$ is determined from the difference $P_{j,s}(k)=I^{(j)}(k + s)-I^{(j)}(k)$ by means of the equation $\Delta_{eff}I^{(j)}(s)=Min\{|P_{j,s}(k)|,\ K-|P_{j,s}(k)|\}$ for at least one particular value of s greater than or equal to one and wherein the selected iteration j is such that after that iteration j each dispersion $\Delta_{eff}I^{(j)}(s)$ is greater than or equal to a particular value.

**7.** Block interleaving device (4) with a block size K for interleaving input digital data items indexed by a variable k, k = {0, ...,K - 1}, performing the interleaving of a data block according to a determined interleaving law $I^{(j)}(k)$, with parameters p and q that are determined, comprising N iterations of a basic cell I of index j forming a so-called turbo structure having two inputs and one output such that for j=1 the two inputs of the cell I are related to each other and such that, in the case where N>1, for j>1 an input of the cell I is related to the output of the cell I of the iteration j-1, each cell I having a turbo structure made up of a first elementary cell $I_0$ and of a second elementary cell, comprising a calculating means suitable for calculating:

- an intermediate value $I_0^{(j)}(k)$ that corresponds to the output of the first elementary cell of the basic cell I of the iteration j, this intermediate value $I_0^{(j)}(k)$ being the result,

for the first iteration, j=1, of applying a first algebraic function $f_0(a, b)$ modulo K with two variables a and b to the input indices k, a=b=k, such that $f_0(a, b)=[-a-pb]_K$,

and, when N>1, for each subsequent iteration j, j=2 to N, of applying the same algebraic function $f_0(a, b)$ to the input indices k and to an output value $I^{(j-1)}(k)$ obtained during the preceding iteration, a=k and b=$I^{j-1}=(k)$; and

- the output value $I^{(j)}(k)$ that corresponds to the output of the second elementary cell and of the basic cell I of the iteration j, this output value $I^{(j)}(k)$ being the result, for a given iteration j, of applying a second algebraic function $f_1(a, b)$ modulo K with two variables a and b to the input indices k and to the intermediate value $I_0^{(j)}(k)$

calculated in the same iteration j, a=k and $b=I_0^{(j)}(k);$ the first algebraic function $f_0(a, b)$ and the second algebraic function $f_1(a, b)$ being linked together so that the output value $I^{(j)}(k)$ output from each iteration j is such

that: $I^{(j)}(k) = \left[\alpha p + k + q \cdot p \cdot I_0^{(j)}(k)\right]_K$ with q and p natural integer parameters, p being a sub-multiple of K such that its value allows a pattern to be preserved, a pattern to be preserved meaning that the order of p multiplexed data streams, each comprising a partition of K/p data items, is preserved after the interleaving operation, $[X]_K$ meaning X modulo K and with $\alpha$ a natural integer parameter such that $\alpha \in \{0, ..., K/p\}$.

**8.** Digital signal intended to be used in an electronic block interleaving device (4) with a block size K and with N iterations of index j, N being greater than or equal to 1, for interleaving digital data items indexed by a variable $k = \{0, ..., K-1\}$ for positioning input digital data items X in an output sequence made up of output digital data items Y in an order determined by an interleaving law $I^{(j)}(k)$ such that $Y(k) = X(I^{(j)}(k))$, the digital signal including at least codes for execution by the electronic device (4) of at least the following steps:

a first step (2) of calculating an intermediate value $I_0^{(j)}(k)$ that for the first iteration, j=1, is the result of applying a first algebraic function $f_0(a, b)$ modulo K with two variables a and b to the input indices k, a=b=k, such that $f_0(a, b)=[-a-pb]_K$, and,

when N>1, for each subsequent iteration j, j=2 to N, is the result of applying the same algebraic function $f_0(a, b)$ to the input indices k and to an output value $I^{(j-1)}(k)$ obtained during the preceding iteration, a=k and b=$I^{(j-1)}(k)$;
a second step (3) of calculating the output value $I^{(j)}(k)$ that, for a given iteration j, is the result of applying a second algebraic function $f_1(a, b)$ modulo K with two variables a and b to the input indices k and to the intermediate

value $I_0^{(j)}(k)$ calculated in the same iteration j, a=k and $b=I_0^{(j)}(k);$
the first algebraic function $f_0(a, b)$ and the second algebraic function $f_1(a, b)$ being linked together so that the output value $I^{(j)}(k)$ output from each iteration j is such that: $I^{(j)}(k) = \left[\alpha p + k + q \cdot p \cdot I_0^{(j)}(k)\right]_K$ with q and p natural integer parameters, p being a sub-multiple of K such that its value allows a pattern to be preserved, a pattern to be preserved meaning that the order of p multiplexed data streams, each comprising a partition of K/p data items, is preserved after the interleaving operation, $[X]_K$ meaning X modulo K and with $\alpha$ a natural

integer parameter such that $\alpha \in \{0, \ldots, K/p\}$.

9. Information medium including program instructions adapted to execute a block interleaving method (1) with a block size K and with N iterations of index $\underline{j}$, N being greater than or equal to 1, for interleaving input digital data items indexed by a variable $k = \{0, \ldots, K\text{-}1\}$ according to any one of Claims 1 to 6, when said program is loaded into and executed in an electronic device (4).

Algorithme RP
(p-1)n=K, K=60

Fig. 1

Algorithme RP
p=23,K=60

Fig. 2

X(k)

k

0            j            K-1        I(k)

I(0)        I(j)

Y(k)

k

0            j

**Fig. 3**

J itérations

k            1

Calcul d'une donnée
intermédiaire    $I_0^{(j)}=f_0(a,b)$

2    $I_0^{(j)}$            3

$I^{(j-1)}(k)$

Calcul d'une donnée
de sortie $I^{(j)}(k)=f_1(a,b)$

$I^{(j)}(k)$

**Fig. 4**

4

$I^{(1)}(k)$  $5_2$    $I^{(2)}(k)$  $5_3$    $I^{(3)}(k)$        $5_j$    $I^{(j)}(k)$

$5_1$

k    I        I        I                I

**Fig. 5**

**Fig. 6a**

**Fig. 6b**

**Fig. 7**

**Fig. 8**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- High-Performance Low-Memory Interleaver Banks for Turbo-Codes. *Proceedings of the 54th IEEE Vehicular Technology Conference (VTC 2001 Fall),* 07 Octobre 2001, 2394-2398